# EUROPEAN PATENT SPECIFICATION

(11) **EP 0 599 989 B1**
(45) Date of publication and mention of the grant of the patent: **22.01.1997**
(21) Application number: 92918506.4
(22) Date of filing: 14.08.1992
(51) Int. Cl.: B41M 5/40, B41M 5/38, G03F 3/10, G03F 1/00, G03F 7/34

(54) **INFRA-RED DIRECT WRITE IMAGING MEDIA**
DURCH INFRAROT DIREKTBESCHREIBBARE AUFZEICHNUNGSMATERIALIEN
MOYENS DE FORMATION D'IMAGES EN ECRITURE DIRECTE PAR INFRAROUGES

(30) Priority: 16.08.1991 US 745924; 19.05.1992 US 885620; 06.08.1992 US 925621
(43) Date of publication of application: 08.06.1994
(73) Proprietor: E.I. DU PONT DE NEMOURS AND COMPANY, Wilmington Delaware 19898 (US)
(72) Inventor: KELLOGG, Reid E., Wilmington, DE 19807 (US); MA, Sheau-Hwa, Chadds Ford, PA 19317 (US); SAVINI, Steven, New Castle, DE 19720 (US); MONROE, Bruce Malcolm, Wilmington, DE 19810 (US); BECKERBAUER, Richard, Wilmington, DE 19806 (US); COVELSKIE, Richard Albert, Sayre, PA 18840 (US); TAYLOR, Harvey Walter, Jr., Sayre, PA 18840 (US); WEED, Gregory Charles, Towanda, PA 18848 (US)
(74) Representative: von Kreisler, Alek, Dipl.-Chem.
(86) International application number: US9206833
(87) International publication number: WO9303928

(56) References cited:
- US-A- 3 855 928
- US-A- 3 898 086
- US-A- 4 123 578
- US-A- 4 244 605
- WO-A 88/04237

## Description

### Background of the Invention

Peel-apart photosensitive elements are used in imaging processes because of their convenience. To produce an image, the element is merely exposed and peeled apart. The process is totally dry. No wet processing is required. If the element comprises a colorant, toning is also unnecessary.

Peel-apart elements comprise an active layer situated between a coversheet and a support. Before exposure, the active layer adheres more strongly to one of the coversheet and the support. Exposure changes the adhesion of the active layer so that, following exposure, the exposed regions of the active layer adheres more strongly to the other of the coversheet and the support. When the element is peeled apart, colored unexposed regions adhere to either the coversheet or support to form a positive image. The exposed regions adhere to the other to form a negative image.

Photopolymer peel-apart elements and processes are well-known. Tonable elements are disclosed, for example, in Cohen and Fan, U.S. Patents 4,282,308 and 4,304,839. Precolored elements are disclosed in Taylor, U.S. Patent 4,489,154. The active layer of these elements comprises a monomer, a binder, and an initiator system. These elements require ultraviolet or visible radiation for imaging; they can not be conveniently imaged with infrared radiation.

Further WO 88/04237 discloses a peel-apart element, which element is containing a support and a particulate or porous layer of image forming material which after exposure may be developed by superimposing a sheet having a surface covered with a(n) (pressure sensitive) adhesive on the exposed particulate or porous layer and peeling it off. This produces an element consisting of sheet, exposed layer of image forming material, adhesive layer and support.

Infrared lasers have been developed as output devices for information storage and processing systems. Since these lasers heat only a small region of the active layer at one time, an image can be built up pixel by pixel. Computer control of ouch processes allows images of high definition to be produced at high speed. A need exists for elements that can be imaged with infra-red radiation and that can be conveniently processed by peeling-apart.

### Summary of the Invention

In one embodiment, this invention is a peel-apart element for laser-induced thermal imaging, said element comprising, in order:
(1) a dimensionally stable support;
(2) an active layer, said active layer consisting essentially of:
   (a) an infra-red absorbing material, and
   (b) a polymeric binder;
(3) an adhesive layer; and
(4) a coversheet,
with the proviso that said element does not contain a release layer between said active layer and said adhesive layer, and
wherein said infra-red absorbing material is present in an amount sufficient to absorb sufficient infra-red radiation to produce the desired change in adhesion of the active layer, and
wherein the adhesive relationship is such that, on peeling apart, regions of said active layer exposed with infra-red radiation adhere to said support while unexposed regions of said active layer adhere to said adhesive layer and said coversheet and are removed with said adhesive layer and said coversheet.

In another embodiment this invention is a peel-apart element for laser-induced thermal imaging, said element comprising, in order:
(1) a dimensionally stable support;
(2) an active layer, said active layer consisting essentially of:
   (a) an infra-red absorbing material, and
   (b) a polymeric binder, and
   (c) a colorant;
(3) an adhesive layer; and
(4) a coversheet,
with the proviso that said element does not contain a release layer between said active layer and said adhesive layer, and
wherein said infra-red absorbing material is present in an amount sufficient to absorb sufficient infra-red radiation to produce the desired change in adhesion of the active layer, and
wherein the adhesive relationship is such that, on peeling apart, regions of said active layer exposed with infra-red radiation adhere to said support while unexposed regions of said active layer adhere to said adhesive layer and said coversheet and are removed with said adhesive layer and said coversheet.

In another embodiment this invention is a peel-apart element for laser-induced thermal imaging, said element comprising, in order:
(1) a coversheet,
(2) an adhesive layer;
(3) an active layer, said active, layer comprising
   (a) a first polymeric binder;
(4) an absorbing layer, said absorbing layer
   comprising: (a) an infra-red absorbing material, and
   (b) a second polymeric binder; and
(5) a dimensionally stable support;
with the proviso that said element does not contain a release layer between said active layer and said adhesive layer, and
wherein said infra-red absorbing material is present in an amount sufficient to absorb sufficient infra-red radiation to produce the desired change in adhesion of the active layer, and
wherein the adhesive relationship is such that, on peeling apart, regions of said active layer that correspond to regions of said element exposed with infra-red radiation adhere to said support while regions of said active layer that correspond to unexposed regions of said element layer adhere to said adhesive layer and said coversheet and are removed with said adhesive layer and said coversheet.

The invention further relates to processes for preparing a colored image from these elements.

### Detailed Description of the Invention

The invention is a peel-apart element for a thermally-induced imaging process. The element comprises, in order: a support, an active layer, an adhesive layer, and a coversheet. As described herein, the element may comprise additional layers. The process of use comprises imagewise exposure of the element by infra-red radiation and removal of the coversheet. As described herein, additional elements and process steps may be used to prepare multicolor images.

In one embodiment, the element comprises, in order: a support, an active layer, an adhesive layer, and a coversheet. In this embodiment the active layer comprises a binder, an infra-red absorbing material, and, optionally, a colorant.

In another embodiment, the element comprises, in order: a support, an absorbing layer, an active layer, an adhesive layer, and a coversheet. In this embodiment the active layer comprises a binder and an infra-red absorbing material, and the active layer comprises a binder and, optionally, a colorant.

In still another embodiment, the element comprises, in order: a support, an absorbing layer, a tackification layer, an active layer, an adhesive layer, and a coversheet. In this embodiment the active layer comprises a binder and an infra-red absorbing material, and the active layer comprises a binder and, optionally, a colorant.

### Active Layer

The active layer is the layer whose adhesive relationship changes on exposure of the element with infra-red radiation. Before exposure the active layer adheres to the adhesive layer and coversheet and is removed when the coversheet is removed. Following exposure, regions of the active layer that correspond to regions of the element exposed by infra-red radiation adhere to the material adjacent to the surface of the active layer opposite the adhesive layer (support, absorbing layer, or tackification layer, depending on the structure of the element) and remain with the support when the coversheet and adhesive layer are removed. The active layer must be frangible to enable high image resolution. The active layer is typically about 1-2 microns thick.

The active layer comprises a binder and, optionally, a colorant. In one embodiment of this invention the active layer also comprises an infra-red absorbing material. The colorant and the infra-red absorbing material may be the same material, or they may be different materials. Other ingredients, such as, for example, plasticizers, pigment dispersants, surfactants, and coating aids, may be present provided they are: compatible with the other ingredients, do not impart unwanted color to the element, and do not adversely affect the operation of the element needed for the practice of the invention.

The binder is a solid polymeric material. The binder must be film forming so a solid layer is formed when the active layer is coated. The binder should be of sufficiently high molecular weight that it is film forming yet of sufficiently low molecular weight that it is soluble in the coating solvent. Polymers with molecular weights in the range to 10,000 to 800,000 may be used to advantage in the practice of this invention. Sufficient binder, typically 40-100%, must be present in the active layer that a film is formed when the active layer is coated.

Numerous polymers may be used as the binder in the active layer. These include: aromatic polycarbonate polymers; aromatic polysulfone polymers; poly(alpha-methyl styrene); copolymers of N-phenylmaleimide consisting of 3-50% N-phenylmaleimide, 40-97% methyl methacrylate, 0-35% styrene, and 0-35% alpha-methyl styrene; acrylic polymers and copolymers, such as, for example, poly(methyl methacrylate), poly(styrene/ethyl acrylate/methyl methacrylate), poly(methacrylic acid/ethyl acrylate/methyl methacrylate); poly(vinyl pyrrolidone); poly(vinyl pyrrolidone/vinyl acetate); esterified styrene/maleic anhydride copolymers, such as, for example, the ethyl, i-propyl, and butyl esters of styrene/maleic anhydride copolymers; polyethylene oxide; polyesters; and polyamides. These polymers are well known to those skilled in the art. Mixtures of polymers that are compatible with each other and the other ingredients of the active layer and that do not alter the adhesive relationships needed for the operation of the element may be used and are considered to be equivalent to the use of a single polymer.

Aromatic polysulfone polymers are polymers which contain sulfone groups and aromatic nuclei in the main polymer chain. They are described in Encyclopedia of Polymer Science and Engineering, Vol. 13, Wiley-Interscience, New York, 1988, pp 196-211. They may be prepared, for example, by the reaction of the disodium or dipotassium salt of a bisphenol, such as, for example, bisphenol A, with a p,p'-dichlorophenylsulfone, such as for example, p,p'-dichlorophenylsulfone. Aromatic polysulfones are sold as Udel® and Radel® resins (Amoco Performance Products, Ridgefield, CT) and Victrex® resins (ICI Americas, Wilmington, DE). Typical aromatic polysulfone polymers include: bisphenol A polysulfone, the copolymer formed from bisphenol A and p,p'-dichlorophenylsulfone; polyarylether sulfone, the copolymer formed from 4,4'-dihydroxydiphenylether and p,p'-dichlorophenylsulfone; and polyphenyl sulfone, the copolymer formed from 4,4'-dihydroxybiphenyl and p,p'-dichlorophenylsulfone. Bisphenol A polysulfone is the preferred aromatic polysulfone binder. Polysulfone polymers with molecular weights in the range of 10,000 to 100,000 maybe used to advantage.

Aromatic polycarbonate polymers are preferred binders. As is well known, polycarbonate polymers are copolymers which comprise carbonate linkages. Polycarbonate polymers are described in Encyclopedia of Polymer Science and Engineering, Vol. 11, Wiley-Interscience, New York, 1988, pp 648-718. Aromatic polycarbonate polymers, polymers which contain carbonate groups and aromatic nuclei in the main polymer chain, are summarized in Table 10 (pp 683-687) of this article. Aromatic polycarbonate polymers can be prepared, for example, from phosgene and bisphenols, such as, for example, bisphenol A, by interfacial polymerization. Transesterification and solution polymerization have also been used to prepare these materials. Typical bisphenols include bisphenol A and o,o,o'o'-tetramethylsubstituted bisphenols, such as, for example, o,o,o'o'-tetramethyl bisphenol A (TMBPA). Aromatic polycarbonate polymers in which the monomer units consist essentially of bisphenol A are more preferred. Bisphenol A polycarbonate, the homopolymer, is most preferred. Aromatic polycarbonate resins are sold as Lexan® resins by the General Electric Co., Pittsfield, MA. Aromatic polycarbonates in the molecular weight range of 10,000 to 100,000 may be used to advantage.

Poly(alpha-methyl styrene) can be used as the binder in the practice of this invention. Poly(alpha-methyl styrene) can be prepared by the polymerization of alpha-methyl styrene by standard cationic polymerization techniques well known to those skilled in the art.

Copolymers of N-phenylmaleimide (NPM) and methyl methacrylate (MMA) can be used as the binder in the practice of this invention. Copolymers containing 3-50% NPM, 40-97% MMA, 0-35% styrene, and 0-35% alpha-methyl styrene can used to advantage. NPM/MMA and NPM/MMA/styrene copolymers are preferred NPM copolymers. The copolymer must be of sufficient molecular weight to be film-forming. Copolymers in the molecular weight range of 40,000 to 800,000 can used to advantage.

NPM copolymers can be prepared by the copolymerization of NPM with other monomers by standard free radical polymerization techniques well known to those skilled in the art. The preparation of NPM/MMA copolymers is described in M. Z. Elsabee, et al., J. Macromol. Sci.-Chem., A24, 1207-1221 (1987).

Other ingredients may be present in the active layer. In one embodiment the active layer comprises a colorant. Important criteria for the selection of the colorant are chemical and thermal stability, brightness of shade, and light and heat fastness. The colorant should have good thermal stability so that it is not decomposed by during imaging. It should not undergo chemical reaction with any of the other components of the active layer either before, after, or during imaging. The colorant also should not alter the unique adhesive relationships required for the operation of the element.

Useful colorants include dyes and pigments. Useful dyes include the Intratherm® dyes, such as, for example, Intratherm® Red P-1339 (anthraquinone type, Disperse Violet 17), available from Crompton and Knowles, Reading, PA. Useful inorganic pigments include, for example, carbon black and graphite. Useful organic pigments include, for example: Rubine F6B (Permanent Rubine F6B (C.I. Pigment 184), Cromophtal® Yellow 3G (C.I. No. Pigment Yellow 93); Hostaperm® Yellow 3G (C.I. No. Pigment Yellow 154); Monastral® Violet R (C.I. No. Pigment Violet 19); 2,9-Dimethylquinacridone (C.I. No. Pigment Red 122); Indofast® Brilliant Scarlet R6300 (C.I. No. Pigment Red 123); Quindo Magenta RV 6803; Monastral® Blue G (C.I. No. Pigment Blue 15), Monastral® Blue (BT 383D) (C.I. No. Pigment Blue 15) Monastral® Blue G (BT 284D) (C.I. No. Pigment Blue 15); and Monastral® Green GT (751D) (C.I. No. Pigment Green 7).

In order to achieve maximum color strength, transparency, and gloss when a pigment is present in the active layer, a dispersant, generally an organic polymeric compound, is used to disperse the fine particles and avoid flocculation and agglomeration. A wide range of dispersants is commercially available. A dispersant will be selected according to the characteristics of the pigment surface and other components in the composition as practiced by those skilled in the art. Standard pigment dispersing techniques, such as ball milling, sand milling, etc, that are apparent to those skilled in the art may be employed.

In accordance with principles well known to those skilled in the art, the concentration of colorant will be chosen to achieve the optical density desired in the final image. The amount of colorant will depend on the thickness of the active layer and the absorption of the colorant. Optical densities greater than 2 at the wavelength of maximum absorption (greater than 99% of incident light absorbed) are typically required. To achieve the desired optical density, pigment concentrations of 5 to 50% by weight of the active layer are typically used.

For the active layer to be imaged by the laser, the active layer must contain an infra-red absorbing material. The infra-red absorbing material must have a strong absorption in the emission region of the exciting laser (typically 750-870 nm) and should have good thermal stability so that it is not decomposed by the imaging radiation. While the infra-red absorbing material and the colorant may be the same material, the need to match the infra-red absorption of the colorant to the emission of the laser greatly restricts the number of colorants which can be used. The use of carbon black and graphite, which may be serve as both colorant and infra-red absorbing material, is well known.

As an alternative, the active layer may be imaged by incorporating therein a separate infra-red absorbing material. For color applications it is preferred that the separate infra-red absorbing material be essentially non-absorbing in the visible so that small amounts used will not affect the color quality of the image. This particularly important if the infra-red absorbing material and colorant are both in the active layer. When the infra-red absorbing material is not in the active layer, but contained in a separate layer, it is important that there be no migration of the infra-red absorbing material into the active layer. In such case, an organic compound with the desired spectral characteristics generally is preferred.

Numerous infra-red absorbing materials are known (see, for example, Infra-red Absorbing Materials, M. Matsuoka, Ed, Plenum, New York, 1990). Infra-red absorbing compounds have been disclosed by, for example: Barlow, U.S. Patent 4,778,128 (poly(substituted)phthalocyanine compounds) DeBoer, EPO Application 0 3121 923 (cyanine dyes); DeBoer, U.S. Patent 4,942,141 (selected squarylium dyes); Evans, U.S. Patent 4,948,776 (chalcogenopyryloarylidene dyes); Evans, U.S. Patent 4,948,777 (bis(chalcogenopyrylo)polymethine dyes); DeBoer, U.S. Patent 4,948,778 (oxyindolizine dyes); DeBoer, U.S. Patent 4,950,639 (bis(aminoaryl)polymethine dyes); Evans, U.S. Patent 4,950,640 (merocyanine dyes); and Chapman, U.S. Patent 4,952,552 (quinoid dyes). Infra-red absorbing indolenine dyes, such as are disclosed in West, U.S. Patent 5,107,063, and Laganis, U.S. Patent 4,882,265, and the infra-red absorbing squarylium dyes disclosed in Kellogg, U.S. Patent 5,019,549 can be used to advantage.

A preferred infra-red absorbing material is SQS, a squarylium dye described in Kellogg, U.S Patent 5,019,549. It has strong absorption in the infra-red and little or no absorption in the visible. The absorption maximum, 814 nm coincides with the wavelength of emission of readily available infra-red diode lasers (750 to 870 nm). A procedure for the synthesis of SQS is given in Gravesteijn, U.S. Patent 4,508,811. Another preferred infra-red absorbing material is IR-125 (absorption maximum 795 nm), an indocyanin dye available from Eastman Kodak, Rochester, NY. This material has little or no absorption in the visible.

The infra-red absorbing materials may be present in the active layer or, if a separate absorbing layer is used, in the absorbing layer, in any concentration that is effective for the intended purpose, i.e., to absorb sufficient infra-red radiation to produce the desired change in the adhesion of the active layer. In general, for the organic compounds, concentrations of 0.1 to 10% of the total coating weight of the layer in which the infra-read absorbing material is contained have been found to be effective. A preferred concentration is 1 to 6% of the total coating weight. When carbon black or graphite are used in the active layer, since they are also used as the colorant, a much higher level, 5 to 50% of the total coating weight, is commonly used in order to achieve the desired optical density for the image.

A plasticizer, when present in the active layer, is used for adjusting the glass transition temperature (T_{g}) and film forming properties of the binder. A plasticizer would be selected to have reasonable compatibility with the binder and other components of the composition. The plasticizer must be thermally and chemically stable so that is not decomposed by the imaging radiation and does not react with the colorant.

Suitable plasticizers include, for example: triacetin (glyceryl triacetate), triphenyl phosphite, dimethyl phthalate, diethyl phthalate, dicyclohexyl phthalate, cyclohexyl benzyl phthalate, dibutoxy ethyl adipate, ethyleneglycol dibenzoate, pentaerythritol tetrabenzoate, glyceryl diacetate, glyceryl carbonate, polyethylene glycol monolaurate, methyl phthalyl ethyl glycolate, o,p-toluenesulfonamide, N-ethyl-p-toluenesulfonamide, and N-cyclohexyl-o,p-toluenesulfonamide. Other plasticizers that yield equivalent results will be apparent to those skilled in the art, and may be employed in accordance with the invention.

Plasticizer may be present in an amount effective for the intended purpose. The combination of binder and plasticizer may be important for balancing the image quality and the scratch and rub resistance of the image. While addition of a plasticizer may increase the image quality, too large a concentration of plasticizer may adversely affect the scratch and rub resistance of the image.

### Topcoat Layer

In another embodiment, a topcoat layer is present between the active layer and the adhesive layer to control image separation during the peel-apart process. The topcoat layer comprises a thin layer of polymer coated on top of the active layer. Layers of about 0.5-1.5 micron thick have been found to be effective. The polymer used in the topcoat layer may be any of the polymers which are useful as binders in the active layer, described above. Although the binder used in the active layer of a given element is typically used in the topcoat layer, the use of other polymers is not precluded. The topcoat layer is conveniently formed by coating a dilute solution of binder in an appropriate solvent over the active layer after the active layer has been coated on the support but before the adhesive layer and support have been laminated to the element.

### Absorbing Layer/Tackification Layer

In another embodiment of this invention, the infra-red absorbing material is contained in separate absorbing layer. The absorbing layer typically comprises a binder and the infra-red absorbing material. The binder may be any of the binders described above. Polymers with glass transition temperatures above room temperature, but below 100°C, have been used to advantage.

Alternatively, the absorbing layer may comprise a thin layer of infra-red absorbing metal, such as, for example, an about 50 nanometer thick layer of aluminum vacuum deposited on the support. Such a layer is considered to be equivalent to the absorbing layer described above.

The absorbing layer may be contiguous to the support and the active layer, or it may be separated from the active layer by a tackification layer. The tackification layer may reduce migration of the infra-red absorbing material from the absorbing layer the active layer. The tackfication layer typically consists of a layer of polymer. This polymer may be any of the binders described above. Polymers with glass transition temperatures above room temperature, but below 100°C, have been used to advantage.

When the element is peeled apart, the absorbing layer, and, if present, the tackification layer, are removed with the support. Since the infra-red absorbing material is contained in the absorbing layer, no infra-red absorbing material (except for material that may have migrated into the active layer) remains in the image formed on the coversheet.

### Support

The support may be any suitable film that has the necessary stiffness and dimensional stability and that exhibits the proper adhesion required for the operation of the element. In elements in which the active layer is adjacent to the support, the adhesive relationship between (1) the support, (2) the active layer, and (3) the adhesive layer is such that, on peeling apart following imaging, regions of the active layer exposed with infra-red radiation adhere to the support. Unexposed regions of the active layer adhere to the adhesive layer and are removed with the adhesive layer and coversheet. In elements in which the active layer and support are not adjacent, due to the presence of an additional layer or layers between the active layer and support, the additional layer or layers adhere to the support on peeling apart.

The support must be dimensionally stable. Since exposure is typically carried out through the support, the support must be transparent to the imaging radiation and not adversely affected by the imaging radiation. In elements in which the infra-red absorbing material is contained in the active layer, an opaque support may be used if the element is to be exposed through the coversheet.

The support is preferably an aromatic polyester film. Aromatic polyester films are composed of film forming aromatic polyester polymers. Aromatic polyesters are polymers which contain ester groups and aromatic nuclei in the main polymer chain, such as, for example, poly(ethylene terephthalate) and poly(ethylene naphthalate).

Poly(ethylene terephthalate) film is the preferred support. The support must be thick enough that it does not tear during the peel-apart process. While the thickness may be varied over a wide range, the support typically has a thickness of from about 5 microns to about 250 microns. A preferred thickness is from about 10 microns to about 100 microns.

### Coversheet/Adhesive Layer

The coversheet is strippable, i.e., removable by peeling it apart from the rest of the element and must have the necessary adhesion to the adhesive layer required for the operation of the element. The coversheet is a sheet material, sufficiently strong to control the peel-apart delamination. Preferred materials are paper and polymeric films, such as, for example, polyethylene terephthalate; polyether sulfone; a polyimide; a poly(vinyl alcohol-co-acetal); a polyolefin, such as, for example, polyethylene or polypropylene; or a cellulose ester, such as, for example, cellulose acetate. If exposure is to be carried out through the coversheet, a coversheet transparent to the imaging radiation is required.

The coversheet should be thick enough that it may be peeled from the element without tearing. While the thickness may be varied over a wide range, films having a thickness of about 15-75 microns are preferred. In general, a rapid rate of coversheet stripping produces better image quality.

Between the coversheet and the active layer, or, if present, the topcoat layer, is an adhesive layer. The adhesive relationship between (1) the support, (2) the active layer or, if present, the topcoat layer, and (3) the adhesive layer is such that, following imaging, exposed regions of the active layer adhere to the support and unexposed regions of the active layer adhere to the adhesive layer and coversheet.

The adhesive layer comprises a polymer whose adhesive strength must be great enough to delaminate the unexposed areas of the active layer from the support, but not strong enough to remove regions of the active layer which correspond to exposed regions of the element from the base. Pressure sensitive adhesive compositions based on polymers and tackifers familiar to those skilled in the art, such as, for example, styrene/butadiene and styrene/isoprene copolymers, acrylics, vinyl acetate/acrylic copolymers, polyvinylbutyral, chlorinated rubbers, silicone polymers, and so forth, may be used. Adhesive compositions are described in Encyclopedia of Polymer Science and Engineering, Vol. 1, Wiley-Interscience, New York, 1985, pp 547-577. Commercial adhesive tapes requiring greater than 4 lb/in pull strength, such as, for example, Scotch Brand Book Tape (3M, St. Paul, MN) may be used to advantage in the practice of this invention. The coating weight of the adhesive should be sufficient to produce good adhesion between the coversheet and the active layer.

### Preparation

The element consisting of support, active layer, adhesive layer, and coversheet, may be prepared by dissolving the binder and the other ingredients of the active layer in a suitable solvent, coating the resulting solution onto the support, and evaporating the solvent. If the active layer comprises an insoluble pigment, it must be dispersed in the solution prior to coating. Conventional coating and dispersing techniques may be used. The topcoat layer, if present, may be coated from a suitable solvent over the dried active layer. The adhesive layer may be coated onto the coversheet using conventional coating techniques. The coversheet and adhesive layer are then laminated to the active layer, and support to produce the element. Alternatively, the active layer and adhesive layer may be coated on the support using multilayer coating techniques and the coversheet laminated to the adhesive layer. Techniques for preparing elements containing additional layers will be obvious to those skilled in the art.

The element may be used in sheet form or in the form of a continuous roll. The continuous roll may comprise a single color or it may comprise alternating areas of different colors, such as, for example, cyan, magenta, yellow, and black.

### Exposure/Image Formation

Imagewise change in adhesion of the active layer is conveniently accomplished by imagewise exposure of the element with an infra-red laser. Following exposure and peeling-apart, in elements in which the active layer is adjacent to the support, imagewise exposed regions adhere to the and unexposed regions adhere to the adhesive layer and coversheet. Following exposure and peeling-apart, in elements in which the active layer is separated from the support by an additional layer or layers (absorbing layer, and, if present, tackification layer), regions of the active layer that correspond to regions of the absorbing layer exposed with infra-red radiation adhere to the absorbing layer, and, if present, the tackification layer, and support. Regions of the active layer that correspond to unexposed regions of the absorbing layer adhere to the adhesive layer and the coversheet and are removed with the adhesive layer and the coversheet.

Exposure is typically carried out through the support. For elements that do not comprise a separate absorbing layer, exposure may be carried out through the coversheet if the coversheet is transparent to the imaging radiation. Following exposure the image is revealed by peeling off the coversheet. The coversheet is preferably removed by peeling back at 180° in a rapid, smooth, continuous motion.

Although various types of lasers may used for exposure, diode lasers emitting in the region of 750 to 880 nm offer substantial advantage in terms of their small size, low cost, stability, reliability, ruggedness, and ease of modulation. Diode lasers emitting in the range of 800 to 880 nm are preferred. Such lasers are commercially available from, for example, Spectra Diode Laboratories (San Jose, CA).

Following exposure though the support and peeling-apart of an element comprising a colorant, a one-color image is produced. A negative image, that is an image in which the exposed regions are colored and the unexposed regions are uncolored, is produced on the support. A positive image, that is an image in which the unexposed regions are colored and the exposed regions are uncolored, is produced on the coversheet.

To prepare a multicolor overlay proof a series of one color images is prepared. Each one color image corresponds to a color separation. The series of one color images is then stacked in register on a white background to produce a multicolor overlay proof. A typical overlay proof consists of yellow, magenta, cyan, and black images produced from the corresponding color separations.

Alternatively, uncolored elements may be used. Following exposure and peeling apart, the revealed adhesive on the coversheet may be toned to produce an image in which the exposed regions are colored. A series of exposed and peeled apart elements may be toned with toners corresponding to different color separations and stacked in register on a white background to produce an overlay proof.

Suitable toners are described in Chu, U.S. Patent 3,620,726; Gray, U.S. Patent 3,909,282; Manger, U.S. Patent 4,215,193; and Ruskin, U.S. Patent 4,661,439. Toners may be applied by dusting with pads dipped in toners as disclosed in Burg, U.S. Patent 3,060,024; hand-operated machine toning as disclosed in Sandner, U.S. Patent 4,019,821; and automatic toning as disclosed in Tobias, U.S. Patent 4,069,791. Colorant may be applied by a transfer process as described in Burg, U.S. Patent 3,060,025, or by using a precolored toning film, such as described in Frohlich, U.S. Patent 4,806,451.

In another embodiment, an element that comprises an active layer and a support, but does not comprise a coversheet and adhesive layer is imagewise exposed, either through the support or through the active layer. The element is processed by rubbing off the unexposed regions. Alternatively, an element comprising a coversheet and an adhesive layer may be laminated to the exposed element, to produce an element comprising a coversheet, adhesive layer, active layer, and support. The element is then peeled apart. If the element comprises a colorant, one-color images similar to those described above are produced. If the element does not comprise a colorant, the adhesive layer may be toned to produce an image as described above.

### Multicolor Integral Images

For the preparation of multicolor integral images, such as surprint proofs, the element is manufactured with a temporary release film instead of a coversheet. When the temporary release film is removed from an unexposed element, the adhesive layer and active layer are not removed with it. This differs from the normal operation in which the adhesive layer and active layer are removed from an unexposed element with the coversheet. Silicon release treated polyethylene terephthalate film is preferred for the temporary release film. The temporary release film should be thick enough that it may be removed from the element without tearing. Films having a thickness of about 15-75 microns may be used to advantage.

To prepare a multicolor integral image, elements in which the active layer comprises a colorant may be used. To produce multicolored images, different colored elements must be used.

The temporary release film is removed from a first element to expose the adhesive layer. The adhesive layer is laminated to a receptor. The element is exposed through the support and peeled apart. On peeling apart, the receptor functions as the coversheet and is equivalent to the coversheet. The regions of the active layer that correspond to exposed regions of the element are removed with the support. The adhesive layer and regions of the active layer that correspond to unexposed regions of the element remain on the receptor to form a one color image that is a positive image of the exposure (unexposed regions are colored).

The temporary release film is removed from a second element, and the exposed adhesive layer laminated to the element consisting of receptor, adhesive layer, and imaged and peeled apart active layer. The resulting element is exposed in register through the support and peeled apart. A two colored image, consisting of: receptor, first adhesive layer, first exposed and peeled apart active layer, second adhesive layer, and second exposed and peeled apart adhesive layer is produced.

These steps may be repeated as many times as desired to produce a multicolor integral image. A typical surprint proof consists of yellow, magenta, cyan, and black images produced from the corresponding color separations.

Alternatively, a multicolor integral image may be prepared from elements which do not contain a colorant. The temporary release film is removed from a first element to expose the adhesive layer. The adhesive layer is laminated to a receptor. The element is exposed through the support and peeled apart. The adhesive layer and regions of the active layer that correspond to unexposed regions of the element remain on the receptor. The regions of the adhesive layer revealed by the peeling apart process are toned as described above to form a one color image that is a negative image of the exposure (exposed regions are colored).

The temporary release film is removed from a second element, and the exposed adhesive layer laminated to the element consisting of receptor; adhesive layer; and imaged, peeled apart, and toned active layer. The resulting element is exposed in register through the support and peeled apart. The regions of the adhesive layer revealed by the peeling apart process are toned as described above. A two color image, consisting of: receptor; first adhesive layer; first exposed, peeled apart, and toned active layer; second adhesive layer; and second exposed, peeled apart, and toned adhesive layer is produced.

The receptor may be any material that has the necessary stiffness dimensional stability and exhibits the necessary adhesion to the adhesive layer required for the operation of the element. The receptor is flat and preferably smooth and opaque. Exemplary materials which may be used as the receptor include opaque polyethylene terephthalate film base, e.g., Melinex® 994 (ICI Americas, Wilmington, DE); and paper stock, e.g., Kromekote® opaque white paper (Champion Paper Co., Stamford, CT), or Cromalin® receptor stock (Du Pont, Wilmington, DE). Paper which has been removably applied to a dimensionally stable support, as described in Osenegg, U.S. Patent 5,053,313, may be used as the receptor. This allows the image to be prepared on any desired receptor stock.

### Integral Photomask

The infra-red sensitive peel-apart element be used as an integral photomask with for another photosensitive material. The element is adhered to the photosensitive material, exposed, and peeled apart to leave the image bearing support adhered to the photosensitive material. The photosensitive material is then exposed to actinic radiation (i.e., radiation that will image the photosensitive material) in the usual manner, the image bearing support removed, and the photosensitive material processed in the usual manner. Alternatively, the infra-red sensitive element may be exposed and peeled apart first and then laminated to the photosensitive material. In this fashion, it is possible to use a computer-driven infra-red laser to image materials that are not sensitive to infra-red radiation.

Numerous types of photosensitive materials are known and used by those skilled in the art. These include, for example: silver halide emulsions; diazo; leuco dye systems; and polymer imaging systems. They are described, for example, in: Light Sensitive Systems, J. Kosar, Wiley, New York, 1965; Imaging Processes and Materials: Neblette's Eighth Edition, J. Sturge, V. Walworth, and A. Shepp, Eds, Van Nostrand Reinhold, New York, 1989; and Handbook of Imaging Materials, A. S. Diamond, Ed, Marcel Dekker, New York, 1991. These materials typically comprise a layer of photosensitive material adhered to a substrate.

The element of this invention may be used to advantage to image polymer imaging systems. Polymer imaging systems typically comprise a layer of a material that is photohardenable, photopolymerizable, photocrosslinkable, photodimerizable, or photosolubilizable adhered to a substrate. These materials, their composition, process of use, and applications, are well known to those skilled in art. They are described, for example in: A. B. Cohen and P. Walker, Imaging Processes and Materials: Neblette's Eighth Edition, J. Sturge, V. Walworth, and A. Shepp, Eds, Van Nostrand Reinhold, New York, 1989, pp. 240-262; Photopolymerization and Photoimaging Science and Technology, N. S. Allen, Ed, Elsevier, New York, 1989; A. Reiser, Photoreactive Polymers: The Science and Technology of Resists, Wiley, New York, 1989; and B. M. Monroe, Radiation Curing: Science and Technology, S. P. Pappas, Ed, Plenum, New York, 1992, 399-440. Photopolymer imaging media for example, typically comprise a monomer, a binder, and a photoinitiator system. They are widely used in printing, proofing and photoresist applications.

When the element of this invention is used to imaging a photopolymer imaging medium, the element is adhered to a photopolymerizable imaging medium comprising a photopolymerizable layer on a substrate. This produces a composite element comprising, in order: coversheet, adhesive layer, active layer, support, photopolymerizable layer, and substrate. The optional topcoat layer may also be present, if desired. For this application it is desirable to use an element in which the infra-red absorbing material and the colorant are both present in the absorbing layer since exposure is typically through the coversheet.

The element thus formed is imaged with an infra-red laser; the coversheet and adhesive layer are peeled apart to leave the image bearing support adhered to the photopolymerizable layer. The photopolymerizable layer is then exposed through the image bearing support in the normal manner, typically with ultraviolet and/or visible radiation. During exposure the image bearing support serves as both and integral photomask and as a coversheet for the photopolymerizable layer.

The support is removed and the photopolymer image is processed and used in the normal manner. In this fashion, printed circuit boards, for example, may be produced by exposure of the composite element with an infra-red laser; peeling apart; exposure of the resulting element in the usual manner; removal of the image bearing support; and washout, etching, stripping, etc, in the usual manner to produce the printed circuit board.

### Industrial Applicability

This invention is particularly useful in the graphic arts field, such as in the area of imagesetting, color proofing wherein the proofs are prepared by overlaying four process color transparency films in registration. The invention is also useful in producing photomask for conventional analog imaging applications such as photopolymerizable compositions used in color proofing, printing plate, etc. The invention can also be integrated into a conventional analog imaging system by laminating the element on the photopolymerizable composition. The composite structure is digitally imaged with the diode laser first, the coversheet peeled apart to form the photomask, then depending on the system and application it is exposed, and after the photomask is removed processed accordingly. Other uses for the high resolution photomask include preparation of printed circuit boards, resists, solder masks, etc.

The advantageous properties of this invention can be observed by reference to the following examples which illustrate, but do not limit, the invention.

### EXAMPLES

### GLOSSARY

- AB-1040: Elvacite® AB-1040; AB dispersant; Du Pont Wilmington, DE
- AR-1030: Elvacite® AB-1030; AB dispersant; Du Pont Wilmington, DE
- AR-1020: Elvacite® AB-1020; AB dispersant; Du Pont Wilmington, DE
- Adcote: Polyester resin; Morton International, Specialty Chemical Group, Chicago, IL
- Black chips: 20% Raven 1035, 20% Raven 450, 40% Elvacite® 2051; and 20% methacrylate dispersant
- Butvar® B-79: Polyvinylbutyral; Monsanto, St. Louis, MO
- Calibre® 300-15: Polycarbonate; Dow, Midland, MI
- Carboset® 1034: Methacrylic acid/ethyl acrylate/methyl methacrylate (21:35:44) copolymer; MW 50,000; acid number 120; T_{g} 87°C; Goodrich, Cleveland, OH
- Carboset® 1623: Styrene/ethyl acrylate/methyl methacrylate copolymer; T_{g} -95°C; Goodrich, Cleveland, OH
- DMEA: Dimethylaminoethanol
- Elvacite® 2041: Poly(methyl methacrylate); Du Pont Wilmington, DE
- Elvacite® 2051: Poly(methyl methacrylate); MW 350,000; Du Pont Wilmington, DE
- Elvax® 40W: Ethylene/vinyl acetate copolymer; Du Pont, Wilmington, DE
- Elvax® 4310: Ethylene/vinyl acetate/methyl methacrylate copolymer; Du Pont Wilmington, DE
- FC-430: Fluorad® FC-430; fluoroaliphatic polymeric esters; CAS 11114-17-3; 3M, St. Paul, MN
- FW200: Carbon black; Degussa Carbon Black Corp., Dublin, OH
- Gentro® 1506: Styrene-butadiene random copolymeric rubber; Gen Corp., Akron, OH
- IR-125: IR dye; Indocyanin green; 2-(7-(1,3-dihydro-1,1-dimethyl-3-(4-sulfobutyl)-2H-benz-(e)indol-2-ylidene)-1,3,5-heptatrienyl)-1,1-dimethyl-3-(4-sulfobutyl)-hydroxide, inner salt, sodium salt CAS 3599-32-4; Eastman Kodak, Rochester, NY
- Joncryl® 682: Solid acrylic resin; molecular weight 1,700, acid number 235; S. C. Johnson & Son, Racine, WI
- Kraton® 1107: Poly(styrene/isoprene) rubber; Shell, Houston, TX
- Lexan® Resins: Polycarbonate resins; General Electric Co., Pittsfield, MA
- Magenta Chips: 40% Quindo Magenta; 50% Elvacite® 2051; 10% methacrylate dispersant
- Methacrylate dispersant: Poly(methylmethacrylate/2-ethylhexyl acrylate) - Desmodur® N adduct; Mn 9,000
- Nylon AQ A90: Aqueous dispersion of polyamide; Toray, Toyko, Japan (distributed by Kennedy and Klim, Red Bank, NJ)
- Parlon® S-300: Chlorinated rubber; Hercules, Wilmington, DE
- PeOx 500: Poylethyloxazoline; Dow, Midland, MI
- Petaflex® Adhesives: Polyester adhesives; Morton International, Specialty Chemical Group, Chicago, IL
- PCL-300: Polycaprolactone; Union Carbide, Danbury, CT
- Polycarbonate: Bisphenol A polycarbonate; MW 20,000 to 25,000; T_{g} 150°C; CAS 24936-68-3; Aldrich Chemical Company, Milwaukee, WI
- Polysulfone: Polysulfone resin; Average MW 30,000; T_{g} 190°C; CAS 25135-51-7; Aldrich Chemical Company, Milwaukee, WI
- Polyox® WSRN 3000: Polyethylene oxide; MW 400,000; Union Carbide, Danbury, CT
- PVP K-90: Polyvinyl pyrrolidone, MW 350,000; GAF, Wayne, NJ
- PVPVA S-630: Poly(vinyl pyrrolidone/vinyl acetate); GAF, Wayne, NJ
- Regal 660R: Carbon black; Cabot Corp., Waltham, MA
- Red P-1339: Intratherm® Red P-1339; C.I Disperse Violet 17; 1-amino-2-bromo-4-hydroxyanthraquinone, CAS 12217-92-4; Crompton & Knowles Corp., Reading, PA
- Rubine F6B: Permanent Rubine F6B; C.I. Pigment 184; Hoechst Celanse Corp., Coventry, RI
- Scarlet Chips: 30% Indofast Brilliant Scarlet; 60% Elvacite® 2051; 10% methacrylate dispersant
- Scriptset® 550: Styrene/maleic anhydride copolymer, ethyl ester; Monsanto, St. Louis, MO
- Scriptset® 661: Styrene/maleic anhydride copolymer, butyl ester; Monsanto, St. Louis, Mo
- SMA-17352A: Styrene/maleic anhydride copolymer, i-propyl ester; Monsanto, St. Louis, MO
- SQS: 4-[[3-[[2,6-Bis(1,1-dimethylethyl)-4H-thiopyran-4-ylidene]methyl]-2-hydroxy-4-oxo-2-cyclobuten-1-ylidene]methyl-2,6-bis(1,1-dimethylethyl)thiopyrylium hydroxide, inner salt; CAS 88878-49-3
- Stereon® 840A: Block styrene/butadiene rubber; Firestone, Akron, OH
- Taktene® CB221: Poly(cis-butadiene); Polysar, Akron, OH
- TIC-5C: 3H-Indolium, 2-[2-[2-chloro-3-[2-(1,3-dihydro-2H-indol-2-ylidene)ethylidene]-1-cyclopenten-1-yl]ethenyl]-1,3,3-trimethyl-, trifluoromethanesulfonate
- Versamid®: Polyamide resin; Henkel, Ambler, PA
- Vitel® 1200: Copolyester resin; T_{g} 71°C; Goodyear, Akron, OH
- Vitel® 2200: Copolyester resin; T_{g} 67°C; Goodyear, Akron, OH
- Vylon® 200: Polyester resin; Toyobo, Osaka, Japan (distributed by Charkit Chemical, Darien, CT)

In the examples which follow, "coating solution" refers to the mixture of solvent and additives which is coated on the support, even though some of the additives may be in suspension rather than in solution. Amounts are expressed in parts by weight.

### Example 1

A coating solution containing the following ingredients was prepared: Regal 660R, 0.32; polycarbonate, 0.05; AB-1030, 0.13; and dichloromethane, 9.50. The composition was stirred with steel beads to completely disperse the pigment and dissolve the polymer, coated on an about 100 micron thick clear polyethylene terephthalate film support using a doctor knife with an about 50 micron wet gap, and air dried to form the active layer. The dried layer was about 1 micron thick.

A topcoat layer was coated onto the dried active layer from a coating solution containing: polycarbonate, 0.5; and dichloromethane, 9.5. The topcoat layer was coated with a doctor knife to produce a dried layer about 1 micron thick. After drying, a layer of transparent Scotch Brand Book Tape (3M Product No. 845; Minnesota Mining and Manufacturing, St. Paul, MN) was applied to the topcoat layer. Scotch Brand Book Tape comprises an adhesive composition, comprising a polymer consisting predominately of 2-octyl acrylate with a minor amount of a low molecular weight predominately aromatic plasticizer or tackifer, on an about 55 micron thick polypropylene coversheet. An element consisting of: coversheet, adhesive layer, topcoat layer, active layer, and polyethylene support was formed.

The element was exposed through the coversheet on a rotating drum with a 100 mW infra-red laser emitting at 830 nm (Spectra Diode Laboratories, Inc., San Jose, CA) and the element peeled apart. The unexposed regions of the active layer adhered to the transparent tape, that is, to the adhesive layer and coversheet, and were removed. The exposed region of the active layer adhered to the support. An image consisting of high contrast, 8 microns wide lines was formed on the support.

### Example 2

The procedure of Example 1 was repeated except that the polycarbonate was replaced with each of: polycarbonate (MW 32,000 to 36,000) from Polysciences (Warrington, PA), Lexan® 101, Lexan® 121, Lexan® 151, and Lexan® 1500. Except for Lexan® 101, each material gave an image comparable to that produced in Example 1. The element formed from Lexan® 101 would not delaminate from the support.

### Control Example A

The procedure of Example 1 was repeated except that the polycarbonate was replaced with each of three polyester resins, Petaflex® 4900, Petaflex® 49021, and Adcote. The polycarbonate was also replaced with an acrylate resin, Elvacite® 2041. The three elements containing polyester resins would not delaminate from the support so no image was formed. The element containing Elvacite® acrylic resin delaminated, but the image formed was of poor quality.

### Control Example B

The procedure of Examples 1 was repeated except that the polycarbonate was omitted. The coating solution contained Regal 660R, 1.5; AB-1030 dispersant, 1.0; and dichloromethane, 7.50. A fair image was obtained, but with a background of black pigment specks in the area intended to be clear . The imaged areas were easily scratched.

### Example 3

The procedures of Examples 1-2 and Control Example A were repeated except that AB-1030 dispersant was replaced with Joncryl® 586. Results comparable to those previously obtained with AB-1030 dispersant were obtained for all binders.

### Example 4

The procedures of Examples 1-3 and Control Example A were repeated except that the added topcoat layer was omitted. In all cases the quality of the separated image was greatly improved by the topcoat. In many cases the carbon black composition would not delaminate at all from the poly(ethylene terephthalate) support in the absence of the topcoat.

### Example 5

The procedure of Examples 1 was repeated except that the dispersant for the carbon black was omitted. The coating solution contained Regal 660R, 1.5; polycarbonate, 1.0; and dichloromethane, 7.5. A good separation image was obtained, but the opacity in the black area was low.

### Example 6

The procedure of Examples 1 was repeated except that a higher polycarbonate content was used. The coating solution contained: Regal 660R, 0.07; polycarbonate, 0.25; AB-1030 dispersant, 0.07; and dichloromethane, 9.50. A fair image, which had both reduced resolution and improved abrasion resistance, was obtained.

### Example 7

A coating solution containing the following ingredients was made up: FW200, 1.0; AR-1040, 1.0; triphenyl phosphite, 0.3; polycarbonate 1.0; dichloromethane, 12.5. The composition was dispersed, coated, imaged, and processed as in Example 1 except that no topcoat layer was applied. The active layer had an optical density of 3.5 and was 2.2 microns thick. At 0.2 J/cm² exposure, 8 micron lines with smooth edges and high contrast were obtained.

### Example 8

A coating solution containing the following ingredients was made up: Rubine F6B, 1.0; AR-1030, 0.275; polycarbonate, 1.0; SQS, 0.05; and dichloromethane, 17.0. The composition was dispersed by milling with steel shots overnight, coated on polyethylene terephthalate film with a doctor knife with an about 24 micron coating gap, and air dried. A layer of Scotch Brand Book Tape was laminated onto the coating.

The element was imaged and processed as in Example 1. At 0.2 J/cm² exposure, very bright red lines were obtained. There were some very fine red lines in the background and the edges of the image lines were slightly jagged.

### Example 9

A coating solution containing the following ingredients was made up: Rubine F6B, 0.75; AB-1030,0.275, triphenyl phosphite, 0.35; polycarbonate, 1.0; SQS, 0.05; and dichloromethane, 15.5. The composition was milled, coated, imaged, and processed as in Example 8. At 0.4 J/cm² exposure, very intense 8 micron red lines with smooth edges on a clear background were obtained.

### Example 10

A coating solution containing the following ingredients was made up: Red P-1339, 0.188; polycarbonate, 0.188, SQS, 0.0015; and dichloromethane, 9.6. The composition was dissolved by magnetic stirring. It was coated, imaged, and processed as in Example 1 except that no topcoat layer was applied. At 0.2 J/cm² exposure, well resolved 8 micron red lines were obtained with a slightly pink background.

### Control Examples C-E

The procedures of Examples 8- 10 were repeated except that SQS was omitted. No image was produced.

### Example 11

A coating solution containing the following ingredients was made up: Regal 660R, 0.32; AB-1020, 0.22; polysulfone, 0.05; and dichloromethane, 9.41. An element consisting of support, active layer, topcoat layer, adhesive layer, and coversheet was prepared following the procedure of Example 1. The element was exposed with an infra-red diode writehead mounted on a Crosfield 646 Scanner, programmed to write 150 lines/in (60 lines/cm) screens. The coating had an optical density of 3.5. At 0.2 J/cm² exposure, half-tone dots from 1% to 60% were obtained.

### Example 12

A coating solution containing the following ingredients was made up: Regal 660R, 0.32; AB-1020, 0.22; poly(alpha-methylstyrene), 0.05; and dichloromethane, 9.41. An element consisting of support, active layer, topcoat layer, adhesive layer, and coversheet was prepared following the procedure of Example 1. The element was imaged and processed following the procedure of Example 11. The coating had an optical density of 3.5. At 0.2 J/cm² exposure, half-tone dots from 1% to 60% were obtained.

### Example 13

This example illustrates the preparation of a N-phenylmaleimide (NPM)/methyl methacrylate (MMA) copolymer by emulsion polymerization.

To a 1 L, 3 necked flask equipped with a mechanical stirrer and a nitrogen blanketed atmosphere was added 300 mL of distilled, nitrogen purged water; 0.5 g of 30% sodium lauryl sulfate; 0.049 mL of 1-dodecylmercaptan (0.0024 mol/mol of monomer); 10 mL of 1.5 wt% aqueous potassium persulfate; and 10 mL of 3 wt% aqueous sodium bisulfate. The reaction mixture was heated in an oil bath to 65°C. A solution of 29.35 g (0.1695 mol) of NPM and 72.15 mL (0.6779 mol) of MMA (commercial grade containing about 100 ppm methyl hydroquinone), preheated to about 60°C, was added to the reaction mixture. After about 10 min, the reaction temperature increased to 85°C. After about 45 min, the temperature had dropped to about 65°C. 2-Propanol (200 mL) and 3 mL of saturated aqueous magnesium sulfate were added to coagulate the reaction emulsion. After stirring with heating for about 1 hr, the reaction mixture was cooled to room temperature. The precipitated solid was filtered off, washed twice with methanol, and dried at 80°C in vacuum. Yield 82.4 g (88%). T_{g} 159°C. Inherent viscosity (CHCl₃ at 25°C) 1.14. M_{w} (size exclusion chromatography) 540,000; Mₙ 155,000. Nitrogen = 2.33 wt% (equivalent to 18.9 mol% NPM)

### Examples 14-21

A coating solution containing the following ingredients was prepared: Regal 660R 0.32; AR-1030 0.13; NPM copolymer 0.05; and dichloromethane 9.50. An element consisting of support, active layer, topcoat layer, adhesive layer, and coversheet was prepared following the procedure of Example 1. The element was imaged and processed following the procedure of Example 11.

The procedure of Example 13 was repeated with methyl methacrylate/N-phenylmaleimide copolymers indicated in Table 1. At 0.2 J/cm² exposure, halftone dots from 1 to 95% were obtained in each case.

**Table 1**

| Example | mol % MMA | mol % NPM | M_{w} | Mₙ |
|---|---|---|---|---|
| 14 | 96.2 | 3.8 | 190.000 | 64,000 |
| 15 | 93.3 | 4.7 | 605,000 | 204,000 |
| 16 | 94.6 | 5.4 | 730,000 | 250,000 |
| 17 | 89.9 | 10.1 | 165,000 | 68,000 |
| 18 | 84.0 | 16.0 | 94,000 | 42,000 |
| 19 | 82.9 | 17.1 | 309,000 | 100,000 |
| 20 | 81.1 | 18.9 | 540,000 | 155,000 |
| 21 | 53.1 | 46.9 | 616,000 | 172,000 |

### Examples 22-23

The procedure of Examples 14-21 was repeated with methyl methacrylate/N-phenylmaleimide/styrene copolymers. Two copolymers, 40:30:30 MMA/NPM/sty and 62:19:19 MMA/NMP/sty, were evaluated. Images similar to those obtained in Examples 14-21 were obtained in each case.

### Example 24

This example illustrates exposure of an element without a coversheet to form a colored image.
Step 1. A coating solution containing the following ingredients was prepared: black chips, 0.9264; Carboset® 1034, 0.4632; distilled water, 6.00; methanol, 6.03; DMEA, 0.28; IR-125, 0.0801. Using a #10 wire rod, the solution was coated to a dry coating thickness of 1-3 microns onto a support of about 10 micron thick clear polyethylene terephthalate film to form an element consisting of active layer and support.
Step 2. The element was exposed through the coating. Exposure was carried out at 824-830 nm with a 100 mW Sanyo SDL-7031-102 laser. The laser produced a 24 micron 1/e² spot with a power of 50-60 mW at the image plane. The pulse duration was varied between 1-1000 microsec to determine the minimum exposure that produced an image.
Step 3. Scotch Brand #810 Magic tape was applied to the element and peeled off. The unexposed areas were removed with the tape. Alternatively, the unexposed areas were wiped with a paper towel. Dots were imageable with 1000 microsec exposure.

### Example 25

This example illustrates exposure of an element without a coversheet to form a colored image. The coversheet and adhesive layer are laminated to the active layer after exposure.
Step 1. A coating solution containing the following ingredients was prepared: magenta chips, 0.9264; Carboset® 1034, 0.4632; distilled water, 6.00; methanol, 6.03; DMEA, 0.28,; and IR-125, 0.0801. Using a #10 wire rod, the coating solution was coated at a dry thickness of 1-3 microns onto a support of 100 micron thick clear polyethylene terephthalate film to produce an element consisting of support and active layer.
Step 2. A coating solution of Vylon® 200 in dichloromethane at 12% solids was coated onto 50 micron thick polyethylene terephthalate film at 52.2 mg/dm² dry coating weight to produce an element consisting of coversheet and adhesive layer.
Step 3. The element formed in Step 1 was imaged by exposing the active layer as described in Example 24, Step 2.
Step 4. The exposed active layer was laminated to the element formed in Step 2 to form an element consisting of support, exposed active layer, adhesive layer, and coversheet. A hot roll laminator (Cromalin® color display system laminator, Du Pont, Wilmington, DE) was used at a laminating speed of about 2 cm/sec and at about 100°C.
Step 5. The element formed in Step 4 was peeled apart. Regions of the active layer that received 100 microsec or more exposure remained with the support. Regions of the active layer that either were not exposed or received less than 100 microsec exposure adhered to the adhesive layer and were removed with the coversheet.
Regions of the active layer that receive 100 microsec or more radiation remained on the support.

### Example 26

The procedure of Example 25 was repeated except that in Step 2 a mixture of 80% Taktene® 221 and 20% Gentro® 1506 was coated onto paper at a coating weight of 120 mg/dm² to produce an element consisting of coversheet and adhesive layer. In Step 4 the exposed active layer was laminated to the adhesive layer using a hot roll laminator at a laminating speed of about 4 cm/sec and at about 104-121°C. The element was peeled apart. Regions of the active layer that received 20 microsec or more radiation remained on the support when the element was peeled apart.

### Example 27

This example illustrates the use of IR-125 in an element consisting of: support, active layer, adhesive layer, and coversheet
Step 1. A coating solution containing the following ingredients was prepared: magenta chips, 0.9264; Carboset® 1034, 0.4632; distilled water, 6.00; methanol, 6.03; DMEA, 0.28,; and IR-125, 0.0801. Using a #10 wire rod, the coating solution was coated at a dry coating weight of 17-21 mg/dm² onto a support of 10 micron thick clear polyethylene terephthalate film to produce an element consisting of support and active layer.
Step 2. A mixture of 80% Taktene® 221 and 20% Gentro® 1506 was coated onto paper at a coating weight of 120 mg/dm² to produce an element consisting of adhesive layer and coversheet. This element was laminated to the element produced in Step 1 using a hot roll laminator at a laminating speed of about 4 cm/sec and at about 104-121°C to produce an element consisting of: support, active layer, adhesive layer, and coversheet.
Step 3. The element produced in Step 2 was exposed through the support using the exposure conditions described in Example 24, step 2. Exposure was carried out through the support.
Step 4. The exposed element was peeled apart. Minimum exposure times to produce an image (the minimum exposure required for the exposed regions to adhere to the support when the coversheet and adhesive layer are removed): 20 microsec.

### Example 28

This example illustrates the use of various binders in elements consisting of: support, active layer, adhesive layer, and coversheet. The active layer did not contain a colorant.

A coating solution containing the following ingredients was prepared: binder as indicated in Table 2, 1.52; distilled water, 13.40; and IR-125, 0.08. The solution was coated as in Example 27, step 1, to produce an element consisting of support and active layer.

A mixture of 80% Taktene® 221 and 20% Gentro® 1506 was coated onto paper at a coating weight of 120 mg/dm² was laminated to this element as described in Example 26 to produce an element consisting of: support, active layer, adhesive layer, and coversheet.

The element was exposed through the support as described in Example 24, Step 2, and peeled apart. Minimum exposure times to produce an image are given in Table 2.

**Table 2**

| Binder | Coating Wt (mg/cm²) | Exposure (microsec)^{a} |
|---|---|---|
| PVP K-90 | 22.8 | 20 |
| PVPVA S-630 | 17.0 | 10 |
| NYLON AQ A90 | 19.0 | 20 |

| | | |
|---|---|---|
| ^{a}Minimum exposure to produce an image. | | |

### Example 29

This example illustrates the use of various binders in elements consisting of: support, active layer, adhesive layer, and coversheet. The active layer did not contain a colorant.

The procedure of Example 28 was repeated except that the coating solution containing the following ingredients: binder as indicated in Table 4, 1.52; methanol, 6.56; distilled water, 6.53; DMEA, 0.30; and IR-125, 0.08. Minimum exposure times to produce an image are given in Table 3.

**Table 3**

| Binder | Coating Wt (mg/cm²) | Exposure (microsec)^{a} |
|---|---|---|
| Scriptset® 661 | 16.9 | 20 |
| Carboset® 1623 | 20.4 | 20 |
| Sty/EA/MMA^{b} | 17.4 | 20 |
| SMA 17352A | 18.6 | 20 |

| | | |
|---|---|---|
| ^{a}Miniinimum exposure to produce an image. | | |
| ^{b}Styrene/ethyl acrylate/methyl methacrylate copolymer, T_{g} = 70°C. | | |

### Example 30

This example illustrates the use of a Elvacite ® 2051 in an element consisting of: support, active layer, adhesive layer, and coversheet. The active layer did not contain a colorant.

The procedure of Example 28 was repeated except that the coating solution containing the following ingredients: Elvacite® 2051, 0.98, and TIC-5C, 0.02, in dichloromethane (12% solids). Coating weight: 21.5 mg/dm². Minimum exposure time to produce an image: 10 microsec.

### Example 31

This example illustrates the use of various binders in an element consisting of: support, active layer, adhesive layer, and coversheet. The active layer did not contain a colorant.

The procedure of Example 28 was repeated except that the coating solution containing the following ingredients in dichloromethane (12% solids): binder as indicated in Table 5, 0.92; PCL-300, 0.06; and TIC-5C, 0.02. Minimum exposure times to produce an image are given in Table 4.

**Table 4**

| Binder | Coating Wt (mg/cm²) | Exposure (microsec)^{a} |
|---|---|---|
| Calibre® 300-15 | 27.1 | 50 |
| Scripset® 550 | 18.9 | 10 |
| Vesamid® 756 | 20.4 | 50 |

| | | |
|---|---|---|
| ^{a}Minimum exposure to produce an image. | | |

### Example 32

This example illustrates an element consisting of: support, absorbing layer, active layer, adhesive layer, and coversheet.
Step 1. A coating solution was made up consisting of 1.50 parts of a material consisting of 25% carbon black dispersed in 75% Vitel® 2200 and 13.50 parts of dichloro-methane was coated onto an about 50 micron thick clear polyethylene terephthalate film with a #4 wire rod at a coating weight of 20-30 mg/dm² to produce an element consisting of support and absorbing layer.
Step 2. A coating solution was made up containing: Polyox® WSRN 3000, 0.99 parts; FC-430, 0.20 part; Carboset® 1034, 29.64 parts; triacetin, 19.76 parts; magenta chip, 49.41 parts; methanol, 34.58 parts; and dichloromethane 657.11 parts. This solution was coated onto about 23 micron thick clear polyethylene terephthalate film at a coating weight of about 17 mg/dm² to produce an element consisting of adhesive layer and temporary support.
Step 3. The element produced in Step 2 was laminated at 104-127°C in a hot roll laminator at 2-3 cm/sec to the element consisting of adhesive layer and coversheet produced in Example 27, Step 2. The temporary support was removed to produce an element consisting of coversheet, adhesive layer, and active layer.
Step 4. The element produce in Step 1 was laminated as described in Step 3 to the element produced in Step 3 to produce an element consisting of: support, absorbing layer, active layer, adhesive layer, and coversheet.
Step 5. The element was exposed as described in Example 24, Step 2, and peeled apart. The exposed active layer preferentially adhered to the absorbing layer. The unexposed active layer preferentially adhered to the adhesive layer. Minimum exposure time to produce an image: 10 microsec. The element was also imaged with a 36 diode array (830 nm) external drum write engine(Crossfield Creo) at an exposure of 400 mJ/cm². The element was mounted on the drum with tape.

### Example 33

This example illustrates an element consisting of: support, absorbing layer, active layer, adhesive layer, and coversheet.
Step 1. Following the general procedure of Example 32, Step 1, a coating solution containing distilled water (98%), Polyox® WSRN 3000 (1.5%), and IR-125 (0.5%) was coated onto about 23 micron thick clear polyethylene terephthalate film at a coating weight of 15 mg/dm² to prepare an element consisting of absorbing layer and support.
Step 2. A coating solution was made up containing: dichloromethane, 350 parts; scarlet chip, 20 parts; Elvacite® 2051, 25 parts; and triacetin, 5 parts. The solution was coated onto 23 micron thick clear polyethylene terephthalate film at a coating weight of about 35 mg/dm² to produce an element consisting of active layer and temporary support.
Step 3. Following the procedure of Steps 3 and 4 of Example 32, an element was produced consisting of: support, absorbing layer, active layer, adhesive layer, and coversheet. This element was exposed as described in Step 5 of Example 32. Minimum exposure time to produce an image: 1000 microsec.

When the procedure was repeated with 4.0% of TIC-5C in the absorbing layer, the minimum exposure time to produce an image was 100 microsec.

### Example 34

This example illustrates an element consisting of support, a thermal absorbing layer, tackification layer, active layer, adhesive layer, and coversheet.
Step 1. A coating solution was made up containing: distilled water, 6.9474 parts, and aqueous black pigment dispersion, 5.0525 parts (solids: 23.75%). The coating solution was coated onto about 50 micron thick clear polyethylene terephthalate film at a coating weight of about 24 mg/dm² using a #3 or #7 wire rod to form an element consisting of support and absorbing layer.
Step 2. A coating solution containing dichloromethane, 13.50 parts and Vitel® 1200, 1.50 parts was coated onto the element formed in Step 1 at a coating weight of about 30 mg/dm² using a #3 bar to form an element consisting of: support, absorbing layer, and tackification layer.
Step 3. A coating solution was made up containing: magenta chip, 0.9264 parts by weight; Carboset® 1034, 0.4632 parts; distilled water, 6.00 parts; methanol, 6.03 parts; and DMEA, 0.28 parts. The coating solution was coated onto about 50 micron thick clear polyethylene terephthalate at a coating weight of about 29 mg/dm² to produce an element consisting of active layer and temporary support.
Step 4. An element consisting of adhesive layer and coversheet was prepared as described in Example 27, Step 2 and laminated to the element produced in Step 3 as described in Example 32, Step 3. The temporary support was removed to produce an element consisting of active layer, adhesive layer, and coversheet.
Step 5. The element produced in Step 2 was laminated to the element produced in Step 4 as described in Example 32, Step 3 to produce an element consisting of support, a thermal absorbing layer, tackification layer, active layer, adhesive layer, and coversheet.
Step 6. The element produced in Step 5 was images as described in Example 24, Step 2, and peeled apart. The exposed regions of the active layer adhered to the absorbing layer. The unexposed regions of the active layer adhered to the adhesive layer. Minimum exposure time to produce an image: 1 millisec.

### Example 35

The procedure of Example 34 was repeated except that the coating solution for the absorbing layer (Step 1) contained 9.7% IR-125 in 3:1 methanol/water. The absorbing layer was coated with a #10 coating rod. Minimum exposure time to produce an image: 1 millisec.

### Example 36

This example illustrates the use of various materials in the adhesive layer.

A coating solution was made up containing: Polyox® WSRN-3000, 0.90%; FC-403, 0.10%; triacetin, 11.2%; Elvacite® 2051 30.81%; Scarlet chips, 51.35%; and TIC-5C, 5.6%. This coating solution was coated onto about 25 micron thick clear polyethylene at a coating weight of about 20 mg/dm² to form an element consisting of support and active layer.

The polymers in Table 5 were coated was from a 10% solution in either dichloromethane or toluene onto about 50 micron thick clear polyethylene terephthalate at a coating weight of about 25 mg/dm² to form an element consisting of adhesive layer and coversheet.

The two elements formed above were laminated together at 107-121°C in a hot roll laminator at about 3 cm/sec to produce an element consisting of coversheet, adhesive layer, active layer, and support.

The element was exposed through the coversheet as described in Example 24, Step 2, and peeled apart. Minimum exposure times to produce an image are shown in Table 5.

**Table 5**

| Binder | Exposure (microsec)^{a} |
|---|---|
| Macromelt® 6238 | 20 |
| Vitel® 2200 | 10 |
| Calibre® 300-15 | no image |
| Stereon® 840A | 10 |
| Parlon® S-300 | 100 |
| Butvar® B-79 | 20 |
| PeOx 500 | 100 |
| Polyvinyl chloride | 100 |
| Elvax® 40W | 100 |
| Elvax® 4310 | 20 |
| Kraton® 1107 | 100 |
| 80%Taktene 221/20% Gentro 1506 | 10 |

| | |
|---|---|
| ^{a}Minimum exposure to produce an image. | |

### Example 37

This example illustrates use of the element as a photomask.

The coversheet was removed from an unexposed sample of Cromalin® negative prepress proofing film (Du Pont, Wilmington, DE), and the image formed Example 12 was laminated in its place to produce an element consisting of: image bearing support, photopolymerizable layer, and substrate. The side of the image that did not bear the active layer was in contact with the photopolymerizable layer of the film. This element was placed in a vacuum frame with the image bearing support up (i.e., facing the light source). A vacuum was drawn on the element and transparency for 90 sec prior to exposure. The element was exposed for about 36 sec with the radiation from a 5 kw high pressure mercury vapor lamp (Violux® 5002S, Exposure Systems Company, Bridgeport, CT) equipped with a photopolymer bulb with a Kokomo filter about 54 in (137 cm) above the element and transparency.

The exposed element was removed from the vacuum frame and the image bearing support removed. The Cromalin® was toned in the normal way with a black Cromalin® toner using a cotton ball dipped in toner to produce a half-tone image corresponding to the image on the mask.

Having described the invention, we now claim the following and their equivalents.

### Example 38

A coating solution containing the following ingredients, expressed in parts by weight, was made up: Regal 660R, 0.333; polyethylene oxide, MW 300,000, 0.025; AB1030, 0.142; toluene, 0.117; and dichloromethane, 9.383. The coating solution was stirred with steel beads to completely disperse the pigment and dissolve the polymer. Then it was coated on 100 micron thick untreated polyethylene terephthalate film with a doctor knife with an about 50 micron wet gap. The coating was air dried to form the active layer (dry coating thickness about 1.5 micron) on the support.

To coat the topcoat layer, a solution containing, expressed in parts by weight: bisphenol A polycarbonate, 0.5; and dichloromethane, 9.5 was coated on top of the active layer and dried. A layer of transparent Scotch Book Tape (3M Product No. 845) was applied to the topcoat layer to produce an element consisting of: support, active layer, topcoat layer, adhesive layer, and coversheet.

The element was exposed through the support on a Crosfield 646 scanner, retrofitted with a CREO (Vancouver BC) writehead using an array of 36 infra-red lasers emitting at 830 nm (Sanyo Semiconductor, SDL-7032-102, Allendale, NJ), to produce a 150 line/in (60 line/cm) screen test pattern, using 200 mJ/cm² of incident laser energy.

After exposure, the coversheet and the support were peeled apart. In the unexposed regions, the active layer adhered to the coversheet and was cleanly removed. In the exposed regions, the active layer adhered to the support and was cleanly removed from the coversheet. High contrast lines as small as 3 microns wide were produced, both on the coversheet (positive image) and on the support (negative image). High density halftone dots from 1 to 95% were produced. The nonimaged regions were very clear, with very few artifacts. The image regions were black, with optical density of at least 4.0.

### Examples 39

Following the procedure of Example 38, a series of elements consisting of support, active layer, topcoat layer, adhesive layer, and coversheet, was produced in which the 300,000 molecular weight polyethylene oxide was replaced with polyethylene oxide (Aldrich, Milwaukee, WI) of molecular weights: 100,000; 200,000; 600,000; 900,000; and 5,00,000. After exposure and peeling-apart, each element produced a readable halftone image, similar to that produced in Example 38. The elements containing higher molecular weight binders produced images with poorer resolution and with irregularity in dot shape. Lower molecular weight binders produced images with lower image density.

## Claims

1. A peel-apart element for laser-induced thermal imaging, said element comprising, in order:
(1) a dimensionally stable support;
(2) an active layer, said active layer consisting essentially of:
(a) an infra-red absorbing material, and
(b) a polymeric binder;
(3) an adhesive layer; and
(4) a coversheet,
with the proviso that said element does not contain a release layer between said active layer and said adhesive layer, and
wherein said infra-red absorbing material is present in an amount sufficient to absorb sufficient infra-red radiation to produce the desired change in adhesion of the active layer, and
wherein the adhesive relationship is such that, on peeling apart, regions of said active layer exposed with infra-red radiation adhere to said support while unexposed regions of said active layer adhere to said adhesive layer and said coversheet and are removed with said adhesive layer and said coversheet.

2. The element of claim 1 additionally comprising a topcoat layer between said active layer and said adhesive layer.

3. The element of claim 1 or claim 2 wherein said binder is selected from the group consisting of: aromatic polycarbonate polymers; aromatic polysulfone polymers; poly(alpha-methyl styrene); copolymers of N-phenylmaleimide consisting of 3-50% N-phenylmaleimide, 40-97% methyl methacrylate, 0-35% styrene, and 0-35% alpha-methyl styrene; acrylic polymers and copolymers; poly(vinyl pyrrolidone); poly(vinyl pyrrolidone/vinyl acetate); esterified styrene/maleic anhydride copolymers; polyethylene oxide; polyesters; and polyamides.

4. The element of claim 1 or claim 2 wherein said support is selected from the group consisting of poly(ethylene terephthalate) and poly(ethylene naphthalate).

5. A peel-apart element for laser-induced thermal imaging, said element comprising, in order:
(1) a dimensionally stable support;
(2) an active layer, said active layer consisting essentially of:
(a) an infra-red absorbing material, and
(b) a polymeric binder, and
(c) a colorant;
(3) an adhesive layer; and
(4) a coversheet,
with the proviso that said element does not contain a release layer between said active layer and said adhesive layer, and
wherein said infra-red absorbing material is present in an amount sufficient to absorb sufficient infra-red radiation to produce the desired change in adhesion of the active layer, and
wherein the adhesive relationship is such that, on peeling apart, regions of said active layer exposed with infra-red radiation adhere to said support while unexposed regions of said active layer adhere to said adhesive layer and said coversheet and are removed with said adhesive layer and said coversheet.

6. The element of claim 5 additionally comprising a topcoat layer between said active layer and said adhesive layer.

7. The element of claim 5 or 6 wherein said binder is selected from the group consisting of: aromatic polycarbonate polymers; aromatic polysulfone polymers; poly(alpha-methyl styrene); copolymers of N-phenylmaleimide consisting of 3-50% N-phenylmaleimide, 40-97% methyl methacrylate, 0-35% styrene, and 0-35% alpha-methyl styrene; acrylic polymers and copolymers; poly(vinyl pyrrolidone); poly(vinyl pyrrolidone/vinyl acetate); esterified styrene/maleic anhydride copolymers; polyethylene oxide; polyesters; and polyamides.

8. The element of claim 5 or 6 wherein said support is selected from the group consisting of poly(ethylene terephthalate) and poly(ethylene naphthalate).

9. A peel-apart element for laser-induced thermal imaging, said element comprising, in order:
(1) a coversheet,
(2) an adhesive layer;
(3) an active layer, said active, layer comprising
(a) a first polymeric binder;
(4) an absorbing layer, said absorbing layer comprising:
(a) an infra-red absorbing material, and
(b) a second polymeric binder; and
(5) a dimensionally stable support;
with the proviso that said element does not contain a release layer between said active layer and said adhesive layer, and
wherein said infra-red absorbing material is present in an amount sufficient to absorb sufficient infra-red radiation to produce the desired change in adhesion of the active layer, and
wherein the adhesive relationship is such that, on peeling apart, regions of said active layer that correspond to regions of said element exposed with infra-red radiation adhere to said support while regions of said active layer that correspond to unexposed regions of said element layer adhere to said adhesive layer and said coversheet and are removed with said adhesive layer and said coversheet.

10. The element of claim 9 additionally comprising a topcoat layer between said active layer and said adhesive layer.

11. The element of claim 9 or 10 wherein said first binder is selected from the group consisting of: aromatic polycarbonate polymers; aromatic polysulfone polymers; poly(alpha-methyl styrene); copolymers of N-phenylmaleimide consisting of 3-50% N-phenylmaleimide, 40-97% methyl methacrylate, 0-35% styrene, and 0-35% alpha-methyl styrene; acrylic polymers and copolymers; poly(vinyl pyrrolidone); poly(vinyl pyrrolidone/vinyl acetate); esterified styrene/maleic anhydride copolymers; polyethylene oxide; polyesters; and polyamides.

12. The element of claim 9 additionally comprising a tackification layer between said active layer and said absorbing layer, said tackification layer comprising a third binder.

13. The element of claim 12 wherein said third binder is a polymer with glass transition temperatures above room temperature, but below 100°C.

14. The element of claim 9 wherein said support is selected from the group consisting of poly(ethylene terephthalate) and poly(ethylene naphthalate).

15. The element of claim 9, 10, 11, 12, 13, or 14 wherein said active layer additionally comprises a colorant, wherein said colorant is present in an amount sufficient to achieve the optical density desired in the final image.

16. The element according to any of claims 9-15 wherein said second binder is a polymer with glass transition temperatures above room temperature, but below 100°C.

17. A process for forming a colored image, said process comprising, in order, the following steps:
(A) imagewise exposing through the support with infra-red radiation an element comprising, in order:
(1) said dimensionally stable support, said support being transparent to infra-red radiation;
(2) an active layer, said active layer comprising:
(a) a first polymeric binder, and
(b) a colorant;
(3) an adhesive layer; and
(4) a coversheet;
with the proviso that said element does not contain a release layer between said active layer and said adhesive layer, and
with the additional proviso that said element comprises an infra-red absorbing material in the layer adjacent to said support, wherein said infra-red absorbing material is present in an amount sufficient to absorb sufficient infra-red radiation to produce the desired change in adhesion of the active layer, and said colorant is present in an amount sufficient to achieve the optical density desired in the final image; and
(B) peeling apart said element by removing said support;
wherein the adhesive relationship is such that, on peeling apart, regions of said active layer that correspond to regions of said element exposed with infra-red radiation adhere to said support and are removed with said support while regions of said active layer that correspond to unexposed regions of said element adhere to said adhesive layer and said receptor to form a one color image.

18. A process for forming a colored image, said process comprising, in order, the following steps:
(A) imagewise exposing through the support with infra-red radiation an element comprising, in order:
(1) said dimensionally stable support, said support being transparent to infra-red radiation;
(2) an active layer, said active layer comprising:
(a) a first polymeric binder, and
(b) a colorant;
(3) an adhesive layer; and
(4) a receptor;
with the proviso that said first element comprises an infra-red absorbing material in the layer adjacent to said support, wherein said infra-red absorbing material is present in an amount sufficient to absorb sufficient infra-red radiation to produce the desired change in adhesion of the active layer, and said colorant is present in an amount sufficient to achieve the optical density desired in the final image; and
(B) peeling apart said element by removing said support;
wherein the adhesive relationship is such that, on peeling apart, regions of said active layer that correspond to regions of said element exposed with infra-red radiation adhere to said support and are removed with said support while regions of said active layer that correspond to unexposed regions of said element adhere to said adhesive layer and said receptor to form a one color image.

19. A process for forming a multicolored image, said process comprising, in order, the following steps:
(A) imagewise exposing with infra-red radiation a first element comprising, in order:
(1) a dimensionally stable support, said support being transparent to infra-red radiation;
(2) an active layer, said active layer comprising:
(a) a first binder, and
(b) a colorant;
(3) an adhesive layer; and
(4) a receptor;
with the proviso that said first element comprises an infra-red absorbing material in the layer adjacent to said support, wherein said infra-red absorbing material is present in an amount sufficient to absorb sufficient infra-red radiation to produce the desired change in adhesion of the active layer, and said colorant is present in an amount sufficient to achieve the optical density desired in the final image;
(B) peeling apart said first element by removing said support;
wherein the adhesive relationship is such that, on peeling apart, regions of said active layer that correspond to regions of said first element exposed with infra-red radiation adhere to said support and are removed with said support, while regions of said active layer that correspond to unexposed regions of said first element layer adhere to said adhesive layer and said receptor to form a one color image;
(C) laminating a second element to the image formed in the preceding step to form an intermediate element, said second element comprising, in order:
(1) dimensionally stable support, said support being transparent to infra-red radiation;
(2) an active layer, said active layer comprising:
(a) a second binder, and
(b) a colorant; and
(3) an adhesive layer;
said adhesive layer of said second element being laminated to the exposed active layer of said image formed in the preceding step;
with the proviso that said second element comprises an infra-red absorbing material in the layer adjacent to said support, wherein said infra-red absorbing material is present in an amount sufficient to absorb sufficient infra-red radiation to produce the desired change in adhesion of the active layer, and said colorant is present in an amount sufficient to achieve the optical density desired in the final image;
(D) imagewise exposing said intermediate element to infra-red radiation through said support of said intermediate element, said exposure being carried out in register with the previously formed image;
(E) peeling apart said intermediate element by removing said support;
wherein the adhesive relationship is such that, on peeling apart, regions of said active layer that correspond to regions of said intermediate element exposed with infra-red radiation adhere to said support and are removed with said support, while regions of said active layer that correspond to unexposed regions of said intermediate element layer adhere to said adhesive layer to form a multicolor image.

20. The process of claim 19 wherein said first and second binders are selected from the group consisting of: aromatic polycarbonate polymers; aromatic polysulfone polymers; poly(alpha-methyl styrene); copolymers of N-phenylmaleimide consisting of 3-50% N-phenylmaleimide, 40-97% methyl methacrylate, 0-35% styrene, and 0-35% alpha-methyl styrene; acrylic polymers and copolymers; poly(vinyl pyrrolidone); poly(vinyl pyrrolidone/vinyl acetate); esterified styrene/maleic anhydride copolymers, polyethylene oxide; polyesters; and polyamides.

21. The process of claim 19 wherein said first element additionally comprises an absorbing layer between said support and said adhesive layer, said infra-red material being present in said absorbing layer, and said absorbing layer comprising a third binder.

22. The process of claim 21 wherein said third binder is a polymer with glass transition temperatures above room temperature, but below 100°C.

23. The process of claim 21 wherein said first element additionally comprising a tackification layer between said active layer and said absorbing layer, said tackification layer comprising a fourth binder.

24. The process of claim 23 wherein said fourth binder is a polymer with glass transition temperatures above room temperature, but below 100°C.

25. The process of claim 19, 21, or 23 wherein steps (C)-(E) are carried out three times to form a multicolor image consisting of yellow, cyan, magenta, and black images.

26. A process for forming a colored image said process comprising, in order, the following steps:
(A) imagewise exposing through the support with infra-red radiation an element comprising in order:
(1) a dimensionally stable support, said support being transparent to infra-red radiation;
(2) an active layer, said active layer comprising:
(a) a first polymeric binder;
(3) said adhesive layer; and
(4) a receptor;
with the proviso that said element comprises an infra-red absorbing material in the layer adjacent to said support, wherein said infra-red absorbing material is present in an amount sufficient to absorb sufficient infra-red radiation to produce the desired change in adhesion of the active layer;
(B) peeling apart said element by removing said support;
wherein the adhesive relationship is such that, on peeling apart, regions of said active layer that correspond to regions of said element exposed with infra-red radiation adhere to said support and are removed with said support exposing said adhesive layer, while regions of said active layer that correspond to unexposed regions of said element adhere to said adhesive layer and said receptor; and
(C) toning the exposed regions of said adhesive layer to form a one color image.

27. A process for forming a multicolored image said process comprising, in order, the following steps:
(A) imagewise exposing with infra-red radiation a first element comprising, in order:
(1) a dimensionally stable support, said support being transparent to infra-red radiation;
(2) an active layer, said active layer comprising a first binder;
(3) an adhesive layer; and
(4) a receptor;
with the proviso that said first element comprises an infra-red absorbing material in the layer adjacent to said support, wherein said infra-red absorbing material is present in an amount sufficient to absorb sufficient infra-red radiation to produce the desired change in adhesion of the active layer;
(B) peeling apart said first element by removing said support;
wherein the adhesive relationship is such that, on peeling apart, regions of said active layer that correspond to regions of said first element exposed with infra-red radiation adhere to said support and are removed with said support exposing said adhesive layer, while regions of said active layer that correspond to unexposed regions of said first element layer adhere to said adhesive layer and said receptor;
(C) toning the exposed regions of said adhesive layer of said first element to form a one color image;
(D) laminating a second element to the image formed in the preceding step to form an intermediate element, said second element comprising, in order:
(1) a dimensionally stable support, said support being transparent to infra-red radiation;
(2) an active layer, said active layer comprising a second binder; and
(3) an adhesive layer;
said adhesive layer of said second element being laminated to said toned active layer of said image formed in the preceding step;
with the proviso that said second element comprises an infra-red absorbing material in the layer adjacent to said support, wherein said infra-red absorbing material is present in an amount sufficient to absorb sufficient infra-red radiation to produce the desired change in adhesion of the active layer;
(E) imagewise exposing said intermediate element to infra-red radiation through said support of said intermediate element, said exposure being carried out in register with the previously formed image;
(F) peeling apart said intermediate element by removing said support;
wherein the adhesive relationship is such that, on peeling apart, regions of said active layer that correspond to regions of said intermediate element exposed with infra-red radiation adhere to said support and are removed with said support exposing said adhesive layer, while regions of said active layer that correspond to unexposed regions of said intermediate element layer adhere to said adhesive layer;
(G) toning the exposed regions of the adhesive layer of said intermediate element to form a multicolor image.

28. The process of claim 27 wherein said first and second binders are selected from the group consisting of: aromatic polycarbonate polymers; aromatic polysulfone polymers; poly(alpha-methyl styrene); copolymers of N-phenylmaleimide consisting of 3-50% N-phenylmaleimide, 40-97% methyl methacrylate, 0-35% styrene, and 0-35% alpha-methyl styrene; acrylic polymers and copolymers; poly(vinyl pyrrolidone); poly(vinyl pyrrolidone/vinyl acetate); esterified styrene/maleic anhydride copolymers; polyethylene oxide; polyesters; and polyamides.

29. The process of claim 28 wherein said first element additionally comprises an absorbing layer between said support and said adhesive layer, said infra-red material being present in said absorbing layer, and said absorbing layer comprising a third binder.

30. The process of claim 29 wherein said third binder is a polymer with glass transition temperatures above room temperature, but below 100°C.

31. The process of claim 29 wherein said first element additionally comprising a tackification layer between said active layer and said absorbing layer, said tackification layer comprising a fourth binder.

32. The process of claim 31 wherein said fourth binder is a polymer with glass transition temperatures above room temperature, but below 100°C.

33. The process of claim 27, 29, or 31 wherein steps (D)-(G) are carried out three times to form a multicolor image consisting of yellow, cyan, magenta, and black images.

34. A process for forming an image, said process comprising, said steps being carried out in order except that step (3) is carried out either before or after step (2):
(1) imagewise exposing with infra-red radiation a peel-apart element for laser-induced thermal imaging, said element comprising, in order:
(a) a dimensionally stable support;
(b) an active layer, said active layer consisting essentially of: an infra-red absorbing material, a first polymeric binder, and a colorant;
(c) an adhesive layer;
(d) a coversheet;
wherein said infra-red absorbing material is present in an amount sufficient to absorb sufficient infra-red radiation to produce the desired change in adhesion of the active layer, and
wherein the adhesive relationship is such that, on peeling apart, regions of said active layer exposed with infra-red radiation adhere to said support, while unexposed regions of said active layer adhere to said adhesive layer and said coversheet and are removed with said adhesive layer and said coversheet, and
(2) peeling apart said element to form a colored image, said colored image comprising said support and exposed portions of said active layer;
(3) laminating said support to a photosensitive material; and
(4) exposing said photosensitive material to actinic radiation through said colored image.

35. The process of claim 34 wherein said photosensitive material is a polymer imaging system comprising a layer of a material that is either photohardenable, photopolymerizable, photocrosslinkable, photodimerizable, or photosolubilizable, said layer adhered to a substrate.

## Patentansprüche

1. Ablösbares Element für das laserinduzierte, thermische Abbilden, wobei das Element in der Reihenfolge:
(1) einen maßhaltigen Träger;
(2) eine aktive Schicht, wobei die aktive Schicht im wesentlichen aus:
(a) einem infrarotabsorbierenden Material und
(b) einem polymeren Bindemittel besteht;
(3) eine Haftschicht und
(4) eine Deckschicht,
umfaßt, mit der Maßgabe, daß das Element keine Abziehschicht zwischen der aktiven Schicht und der Haftschicht enthält, und worin das infrarotabsorbierende Material in einer Menge vorliegt, die ausreichend ist, um genügend Infrarotstrahlung zu absorbieren, um die erwünschte Änderung der Haftung der aktiven Schicht zu erzeugen, und worin die Haftungsbeziehung derartig ist, daß beim Ablösen Bereiche der aktiven Schicht, die mit Infrarotstrahlung belichtet werden, an dem Träger haften, während unbelichtete Bereiche der aktiven Schicht an der Haftschicht und der Deckschicht haften und mit der Haftschicht und der Deckschicht entfernt werden.

2. Element gemäß Anspruch 1, das zusätzlich eine Schutzschicht zwischen der aktiven Schicht und der Haftschicht umfaßt.

3. Element gemäß Anspruch 1 oder Anspruch 2, worin das Bindemittel aus der Gruppe, bestehend aus aromatischen Polycarbonat-Polymeren, aromatischen Polysulfon-Polymeren, Poly(α-methylstyrol), Copolymeren von N-Phenylmaleimid, bestehend aus 3-50% N-Phenylmaleimid, 40-97% Methylmethacrylat, 0-35% Styrol und 0-35 % α-Methylstyrol, Acrylpolymeren und -copolymeren, Poly(vinylpyrrolidon), Poly(vinylpyrrolidon/vinylacetat), veresterten Styrol/Maleinsäureanhydrid-Copolymeren, Polyethylenoxid, Polyestern und Polyamiden, ausgewählt ist.

4. Element gemäß Anspruch 1 oder Anspruch 2, worin der Träger aus der Gruppe, bestehend aus Poly(ethylenterephthalat) und Poly(ethylennaphthalat), ausgewählt ist.

5. Ablösbares Element für das laserinduzierte, thermische Abbilden, wobei das Element in der Reihenfolge:
(1) einen maßhaltigen Träger;
(2) eine aktive Schicht, wobei die aktive Schicht im wesentlichen aus:
(a) einem infrarotabsorbierenden Material und
(b) einem polymeren Bindemittel und
(c) einem Farbmittel besteht;
(3) eine Haftschicht und
(4) eine Deckschicht,
umfaßt, mit der Maßgabe, daß das Element keine Abziehschicht zwischen der aktiven Schicht und der Haftschicht enthält, und worin das infrarotabsorbierende Material in einer Menge vorliegt, die ausreichend ist, um genügend infrarote Strahlung zu absorbieren, um die erwünschte Änderung der Haftung der aktiven Schicht zu erzeugen, und worin die Haftungsbeziehung derartig ist, daß beim Ablösen Bereiche der aktiven Schicht, die mit Infrarotstrahlung belichtet wurden, an dem Träger haften, während unbelichtete Bereiche der aktiven Schicht an der Haftschicht und der Deckschicht haften und mit der Haftschicht und der Deckschicht entfernt werden.

6. Element gemäß Anspruch 5, das zusätzlich eine Schutzschicht zwischen der aktiven Schicht und der Haftschicht umfaßt.

7. Element gemäß Anspruch 5 oder 6, worin das Bindemittel aus der Gruppe, bestehend aus aromatischen Polycarbonat-Polymeren, aromatischen Polysulfon-Polymeren, Poly(α-methylstyrol), Copolymeren von N-Phenylmaleimid, bestehend aus 3-50% N-Phenylmaleimid, 40-97% Methylmethacrylat, 0-35% Styrol und 0-35 % α-Methylstyrol, Acrylpolymeren und -copolymeren, Poly(vinyl- pyrrolidon), Poly(vinylpyrrolidon/vinylacetat), veresterten Styrol/Maleinsäureanhydrid-Copolymeren, Polyethylenoxid, Polyestern und Polyamiden, ausgewählt ist.

8. Element gemäß Anspruch 5 oder Anspruch 6, worin der Träger aus der Gruppe, bestehend aus Poly(ethylenterephthalat) und Poly(ethylennaphthalat), ausgewählt ist.

9. Ablösbares Element für das laserinduzierte, thermische Abbilden, wobei das Element in der Reihenfolge:
(1) eine Decksicht,
(2) eine Haftschicht
(3) eine aktive Schicht, wobei die aktive Schicht (a) ein erstes polymeres Bindemittel umfaßt;
(4) eine absorbierende Schicht, wobei die absorbierende Schicht:
(a) eine infrarotabsorbierendes Material und
(b) ein zweites polymeres Bindemittel unfaßt; und
(5) einen maßhaltigen Träger umfaßt,
mit der Maßgabe, daß das Element keine Abziehschicht zwischen der aktiven Schicht und der Haftschicht enthält, und worin das infrarotabsorbierende Material in einer Menge vorliegt, die ausreichend ist, um genügend infrarote Strahlung zu absorbieren, um die erwünschte Änderung der Haftung der aktiven Schicht zu erzeugen, und worin die Haftungsbeziehung derartig ist, daß beim Ablösen Bereiche der aktiven Schicht, die Bereichen des Elements entsprechen, die mit Infrarotstrahlung belichtet werden, an dem Träger haften, während Bereiche der aktiven Schicht, die unbelichteten Bereichen der Elementschicht entsprechen, an der Haftschicht und der Deckschicht haften und mit der Haftschicht und der Deckschicht entfernt werden.

10. Element gemäß Anspruch 9, das zusätzlich eine Schutzschicht zwischen der aktiven Schicht und der Haftschicht umfaßt.

11. Element gemäß Anspruch 9 oder 10, worin das erste Bindemittel aus der Gruppe, bestehend aus aromatischen Polycarbonat-Polymeren, aromatischen Polysulfon-Polymeren, Poly(α-methylstyrol), Copolymeren von N-Phenylmaleimid, bestehend aus 3-50% N-Phenylmaleimid, 40-97% Methylmethacrylat, 0-35% Styrol und 0-35 % α-Methylstyrol, Acrylpolymeren und -copolymeren, Poly(vinyl- pyrrolidon), Poly(vinylpyrrolidon/vinylacetat), veresterten Styrol/Maleinsäureanhydrid-Copolymeren, Polyethylenoxid, Polyestern und Polyamiden, ausgewählt ist.

12. Element gemäß Anspruch 9, das zusätzlich eine Klebrigkeitsschicht zwischen der aktiven Schicht und der absorbierenden Schicht umfaßt, wobei die Klebrigkeitsschicht ein drittes Bindemittel umfaßt.

13. Element gemäß Anspruch 12, worin das dritte Bindemittel ein Polymer mit Glasübergangstemperaturen oberhalb Raumtemperatur, jedoch unterhalb 100 °C ist.

14. Element gemäß Anspruch 9, worin der Träger aus der Gruppe, bestehend aus Poly(ethylenterephthalat) und Poly(ethylennaphthalat), ausgewählt ist.

15. Element gemäß der Ansprüche 9, 10, 11, 12, 13 oder 14, worin die aktive Schicht zusätzlich ein Farbmittel umfaßt, wobei das Farbmittel in einer Menge vorliegt, die ausreichend ist, um die erwünschte optische Dichte in dem fertigen Bild zu erreichen.

16. Element gemäß irgendeinem der Ansprüche 9-15, worin das zweite Bindemittel ein Polymer mit Glasübergangstemperaturen oberhalb Raumtemperatur, jedoch unterhalb 100 °C ist.

17. Verfahren zur Bildung eines gefärbten Bildes, wobei das Verfahren in der Reihenfolge die folgenden Stufen umfaßt:
(A) bildweises Belichten eines Elements durch den Träger mit Infrarotstrahlung, das in der Reihenfolge:
(1) den maßhaltigen Träger, wobei der Träger gegenüber Infrarotstrahlung transparent ist,
(2) eine aktive Schicht, wobei die aktive Schicht:
(a) ein erstes polymeres Bindemittel und
(b) ein Farbmittel umfaßt;
(3) eine Haftschicht und
(4) eine Deckschicht,
umfaßt, mit der Maßgabe, daß das Element keine Abziehschicht zwischen der aktiven Schicht und der Haftschicht enthält, und mit der zusätzlichen Maßgabe, daß das Element ein infrarotabsorbierendes Material in der dem Träger benachbarten Schicht umfaßt, worin das infrarotabsorbierende Material in einer Menge vorliegt, die ausreichend ist, um genügend Infrarotstrahlung zu absorbieren, um die erwünschte Änderung der Haftung der aktiven Schicht zu erzeugen, und worin das Farbmittel in einer Menge vorliegt, die ausreichend ist, um die erwünschte optische Dichte in dem fertigen Bild zu erreichen; und
(B) Ablösen des Elements durch Entfernen des Trägers, worin die Haftungsbeziehung derartig ist, daß beim Ablösen Bereiche der aktiven Schicht, die Bereichen des Elements entsprechen, die mit Infrarotstrahlung belichtet wurden, an dem Träger haften und mit dem Träger entfernt werden, während Bereiche der aktiven Schicht, die den unbelichteten Bereichen des Elements entsprechen, an der Haftschicht und dem Rezeptor haften, um ein Einfarbenbild zu erzeugen.

18. Verfahren zur Bildung eines gefärbten Bildes. wobei das Verfahren in der Reihenfolge die folgenden Stufen umfaßt:
(A) bildweises Belichten eines Elements durch den Träger mit Infrarotstrahlung, das in der Reihenfolge:
(1) den maßhaltigen Träger, wobei der Träger gegenüber Infrarotstrahlung transparent ist,
(2) eine aktive Schicht, wobei die aktive Schicht:
(a) ein erstes polymeres Bindemittel und
(b) ein Farbmittel umfaßt;
(3) eine Haftschicht und
(4) einen Rezeptor
umfaßt, mit der Maßgabe, daß das erste Element ein infrarotabsorbierendes Material in der dem Träger benachbarten Schicht umfaßt, worin das infrarotabsorbierende Material in einer Menge vorliegt, die ausreichend ist, um genügend Infrarotstrahlung zu absorbieren, um die erwünschte Änderung der Haftung der aktiven Schicht zu erzeugen, und worin das Farbmittel in einer Menge vorliegt, die ausreichend ist, um die erwünschte optische Dichte in dem fertigen Bild zu erreichen; und
(B) Ablösen des Elements durch Entfernen des Trägers, worin die Haftungsbeziehung derartig ist, daß beim Ablösen Bereiche der aktiven Schicht, die Bereichen des Elements entsprechen, die mit Infrarotstrahlung belichtet wurden, an dem Träger haften und mit dem Träger entfernt werden, während Bereiche der aktiven Schicht, die den unbelichteten Bereichen des Elements entsprechen, an der Haftschicht und dem Rezeptor haften, um ein Einfarbenbild zu erzeugen.

19. Verfahren zur Bildung eines Mehrfarbenbildes, wobei das Verfahren in der Reihenfolge die folgenden Stufen umfaßt:
(A) bildweises Belichten eines ersten Elements mit Infrarotstrahlung, das in der Reihenfolge:
(1) einen maßhaltigen Träger, wobei der Träger gegenüber Infrarotstrahlung transparent ist,
(2) eine aktive Schicht, wobei die aktive Schicht:
(a) ein erstes Bindemittel und
(b) ein Farbmittel umfaßt;
(3) eine Haftschicht und
(4) einen Rezeptor
umfaßt, mit der Maßgabe, daß das erste Element ein infrarotabsorbierendes Material in der dem Träger benachbarten Schicht umfaßt, worin das infrarotabsorbierende Material in einer Menge vorliegt, die ausreichend ist, um genügend Infrarotstrahlung zu absorbieren, um die erwünschte Änderung der Haftung der aktiven Schicht zu erzeugen, und worin das Farbmittel in einer Menge vorliegt, die ausreichend ist, um die erwünschte optische Dichte in dem fertigen Bild zu erreichen; und
(B) Ablösen des ersten Elements durch Entfernen des Trägers, worin die Haftungsbeziehung derartig ist, daß beim Ablösen Bereiche der aktiven Schicht, die Bereichen des ersten Elements entsprechen, die mit Infrarotstrahlung belichtet wurden, an dem Träger haften und mit dem Träger entfernt werden, während Bereiche der aktiven Schicht, die den unbelichteten Bereichen des ersten Elements entsprechen, an der Haftschicht und dem Rezeptor haften, um ein Einfarbenbild zu erzeugen;
(C) Laminieren eines zweiten Elements auf das Bild, das in der vorhergehenden Stufe gebildet wurde, um ein intermediäres Element zu bilden, wobei das zweite in der Reihenfolge:
(1) einen maßhaltigen Träger, wobei der Träger gegenüber Infrarotstrahlung transparent ist,
(2) eine aktive Schicht, wobei die aktive Schicht:
(a) ein erstes Bindemittel und
(b) ein Farbmittel umfaßt; und
(3) eine Haftschicht
umfaßt, wobei die Haftschicht des zweiten Elements, auf die belichtete, aktive Schicht des in der vorhergehenden Stufe gebildeten Bildes laminiert wird, mit der Maßgabe, daß das zweite Element ein infrarotabsorbierendes Material in der dem Träger benachbarten Schicht umfaßt, worin das infrarotabsorbierende Material in einer Menge vorliegt, die ausreichend ist, um genügend Infrarotstrahlung zu absorbieren, um die erwünschte Änderung der Haftung der aktiven Schicht zu erzeugen, und worin das Farbmittel in einer Menge vorliegt, die ausreichend ist, um die erwünschte optische Dichte in dem fertigen Bild zu erreichen;
(D) bildweises Belichten des intermediären Elements mit Infrarotstrahlung durch den Träger des intermediären Elements, wobei die Belichtung paßgenau mit dem vorher gebildeten Bild durchgeführt wird;
(E) Ablösen des intermediären Elements durch Entfernen des Trägers, worin die Haftungsbeziehung derartig ist, daß beim Ablösen Bereiche der aktiven Schicht, die Bereichen des intermediären Elements entsprechen, die mit Infrarotstrahlung belichtet wurden, an dem Träger haften und mit dem Träger entfernt werden, während Bereiche der aktiven Schicht, die den unbelichteten Bereichen der intermediären Elementschicht entsprechen, an der Haftschicht haften, um ein Mehrfarbenbild zu erzeugen.

20. Verfahren gemäß Anspruch 19, worin das erste und das zweite Bindemittel aus der Gruppe, bestehend aus aromatischen Polycarbonat-Polymeren, aromatischen Polysulfon-Polymeren, Poly(α-methylstyrol), Copolymeren von N-Phenylmaleimid, bestehend aus 3-50% N-Phenylmaleimid, 40-97% Methylmethacrylat, 0-35% Styrol und 0-35 % α-Methylstyrol, Acrylpolymeren und -copolymeren, Poly(vinylpyrrolidon), Poly(vinylpyrrolidon/vinylacetat), veresterten Styrol/Maleinsäureanhydrid-Copolymeren, Polyethylenoxid, Polyestern und Polyamiden, ausgewählt sind.

21. Verfahren gemäß Anspruch 19, worin das erste Element zusätzlich eine absorbierende Schicht zwischen dem Träger und der Haftschicht umfaßt, das Infrarot-Material in der absorbierenden Schicht vorliegt, und die absorbierende Schicht ein drittes Bindemittel umfaßt.

22. Verfahren gemäß Anspruch 21, worin das dritte Bindemittel ein Polymer mit Glasübergangstemperaturen oberhalb Raumtemperatur, jedoch unterhalb 100 °C ist.

23. Verfahren gemäß Anspruch 21, worin das erste Element zusätzlich eine Klebrigkeitsschicht zwischen der aktiven Schicht und der absorbierenden Schicht umfaßt, wobei die Klebrigkeitsschicht ein viertes Bindemittel umfaßt.

24. Verfahren gemäß Anspruch 23, worin das vierte Bindemittel ein Polymer mit Glasübergangstemperaturen oberhalb Raumtemperatur, jedoch unterhalb 100 °C ist.

25. Verfahren gemäß den Ansprüchen 19, 21 oder 23, worin die Stufen (C)-(E) dreimal durchgeführt werden, um ein Mehrfarbenbild herzustellen, das aus gelben, cyanfarbenen, magentafarbenen und schwarzen Bildern besteht.

26. Verfahren zur Bildung eines gefärbten Bildes, wobei das Verfahren in der Reihenfolge die folgenden Stufen umfaßt:
(A) bildweises Belichten eines Elements mit Infrarotstrahlung durch den Träger, das in der Reihenfolge:
(1) einen maßhaltigen Träger, wobei der Träger gegenüber Infrarotstrahlung transparent ist,
(2) eine aktive Schicht, wobei die aktive Schicht:
(a) ein erstes polymeres Bindemittel umfaßt;
(3) eine Haftschicht und
(4) einen Rezeptor
umfaßt, mit der Maßgabe, daß das Element ein infrarotabsorbierendes Material in der dem Träger benachbarten Schicht umfaßt, worin das infrarotabsorbierende Material in einer Menge vorliegt, die ausreichend ist, um genügend Infrarotstrahlung zu absorbieren, um die erwünschte Änderung der Haftung der aktiven Schicht zu erzeugen,
(B) Ablösen des Elements durch Entfernen des Trägers, worin die Haftungsbeziehung derartig ist, daß beim Ablösen Bereiche der aktiven Schicht, die Bereichen des Elements entsprechen, die mit Infrarotstrahlung belichtet wurden, an dem Träger haften und mit dem Träger entfernt werden, wobei die Haftschicht freigelegt wird, während Bereiche der aktiven Schicht, die den unbelichteten Bereichen des Elements entsprechen, an der Haftschicht und dem Rezeptor haften, und
(C) Tonen der belichteten Bereiche der Haftschicht unter Bildung eines Einfarbenbildes.

27. Verfahren zur Bildung eines Mehrfarbenbildes, wobei das Verfahren in der Reihenfolge die folgenden Stufen umfaßt:
(A) bildweises Belichten eines ersten Elements mit Infrarotstrahlung, das in der Reihenfolge:
(1) einen maßhaltigen Träger, wobei der Träger gegenüber Infrarotstrahlung transparent ist,
(2) eine aktive Schicht, wobei die aktive Schichtein erstes Bindemittel umfaßt;
(3) eine Haftschicht und
(4) einen Rezeptor
umfaßt, mit der Maßgabe, daß das erste Element ein infrarotabsorbierendes Material in der dem Träger benachbarten Schicht umfaßt, worin das infrarotabsorbierende Material in einer Menge vorliegt, die ausreichend ist, um genügend Infrarotstrahlung zu absorbieren, um die erwünschte Änderung der Haftung der aktiven Schicht zu erzeugen;
(B) Ablösen des ersten Elements durch Entfernen des Trägers, worin die Haftungsbeziehung derartig ist, daß beim Ablösen Bereiche der aktiven Schicht, die Bereichen des ersten Elements entsprechen, die mit Infrarotstrahlung belichtet wurden, an dem Träger haften und mit dem Träger entfernt werden, wobei die Haftschicht freigelegt wird, während Bereiche der aktiven Schicht, die den unbelichteten Bereichen des ersten Elements entsprechen, an der Haftschicht und dem Rezeptor haften;
(C) Tonen der belichteten Bereiche der Haftschicht des ersten Elements, um ein Einfarbenbild zu erzeugen;
(D) Laminieren eines zweiten Elements auf das Bild, das in der vorhergehenden Stufe gebildet wurde, um ein intermediäres Element zu bilden, wobei das zweite Element in der Reihenfolge:
(1) einen maßhaltigen Träger, wobei der Träger gegenüber Infrarotstrahlung transparent ist,
(2) eine aktive Schicht, wobei die aktive Schichtein zweites Bindemittel umfaßt; und
(3) eine Haftschicht
umfaßt, wobei die Haftschicht des zweiten Elements, an die getonte, aktive Schicht des in der vorhergehenden Stufe gebildeten Bildes laminiert wird, mit der Maßgabe, daß das zweite Element ein infrarotabsorbierendes Material in der dem Träger benachbarten Schicht umfaßt, worin das infrarotabsorbierende Material in einer Menge vorliegt, die ausreichend ist, um genügend Infrarotstrahlung zu absorbieren, um die erwünschte Änderung der Haftung der aktiven Schicht zu erzeugen,
(E) bildweises Belichten des intermediären Elements mit Infrarotstrahlung durch den Träger des intermediären Elements, wobei die Belichtung paßgenau mit dem vorher gebildeten Bild durchgeführt wird;
(F) Ablösen des intermediären Elements durch Entfernen des Trägers, worin die Haftungsbeziehung derartig ist, daß beim Ablösen Bereiche der aktiven Schicht, die Bereichen des intermediären Elements entsprechen, die mit Infrarotstrahlung belichtet wurden, an dem Träger haften und mit dem Träger entfernt werden, wobei die Haftschicht freigelegt wird, während Bereiche der aktiven Schicht, die unbelichteten Bereichen der intermediären Elementschicht entsprechen, an der Haftschicht haften;
(G) Tonen der belichteten Bereiche der Haftschicht des intermediären Elements, um ein Mehrfarbenbild zu erzeugen.

28. Verfahren gemäß Anspruch 27, worin das erste und das zweite Bindemittel aus der Gruppe, bestehend aus aromatischen Polycarbonat-Polymeren, aromatischen Polysulfon-Polymeren, Poly(α-methylstyrol), Copolymeren von N-Phenylmaleimid, bestehend aus 3-50% N-Phenylmaleimid, 40-97% Methylmethacrylat, 0-35% Styrol und 0-35 % α-Methylstyrol, Acrylpolymeren und -copolymeren, Poly(vinylpyrrolidon), Poly(vinylpyrrolidon/vinylacetat), veresterten Styrol/Maleinsäureanhydrid-Copolymeren, Polyethylenoxid, Polyestern und Polyamiden, ausgewählt sind.

29. Verfahren gemäß Anspruch 28, worin das erste Element zusätzlich eine absorbierende Schicht zwischen dem Träger und der Haftschicht umfaßt, das Infrarot-Material in der absorbierenden Schicht vorliegt, und die absorbierende Schicht ein drittes Bindemittel umfaßt.

30. Verfahren gemäß Anspruch 29, worin das dritte Bindemittel ein Polymer mit Glasübergangstemperaturen oberhalb Raumtemperatur, jedoch unterhalb 100 °C ist.

31. Verfahren gemäß Anspruch 29, worin das erste Element zusätzlich eine Klebrigkeitsschicht zwischen der aktiven Schicht und der absorbierenden Schicht umfaßt, wobei die Klebrigkeitsschicht ein viertes Bindemittel umfaßt.

32. Verfahren gemäß Anspruch 31, worin das vierte Bindemittel ein Polymer mit Glasübergangstemperaturen oberhalb Raumtemperatur, jedoch unterhalb 100 °C ist.

33. Verfahren gemäß den Ansprüchen 27, 29 oder 31, worin die Stufen (D)-(G) dreimal durchgeführt werden, um ein Mehrfarbenbild herzustellen, das aus gelben, cyanfarbenen, magentafarbenen und schwarzen Bildern besteht.

34. Verfahren zur Bildung eines Bildes - wobei die Stufen die in der folgenden Reihenfolge durchgeführt werden, außer, daß die Stufe (3) entweder vor oder nach der Stufe (2) durchgeführt wird - umfassend:
(1) bildweises Belichten eines ablösbaren Elements für laserinduziertes, thermisches Abbilden mit Infrarotstrahlung, wobei das Element in der Reihenfolge:
(a) einen maßhaltigen Träger;
(b) eine aktive Schicht, wobei die aktive Schicht im wesentlichen aus:
einem infrarotabsorbierenden Material, einem ersten polymeren Bindemittel und einem Farbmittel besteht;
(c) eine Haftschicht;
(d) eine Deckschicht;
umfaßt, worin worin das infrarotabsorbierende Material in einer Menge vorliegt, die ausreichend ist, um genügend Infrarotstrahlung zu absorbieren, um die erwünschte Änderung der Haftung der aktiven Schicht zu erzeugen, und worin die Haftungsbeziehung derartig ist, daß beim Ablösen Bereiche der aktiven Schicht, die mit Infrarotstrahlung belichtet wurden, an dem Träger haften, während unbelichtete Bereiche der aktiven Schicht an der Haftschicht und der Deckschicht haften und mit der Haftschicht und der Deckschicht entfernt werden; und
(2) Ablösen des Elements unter Bildung eines gefärbten Bildes, wobei das gefärbte Bild den Träger und belichtete Teile der aktiven Schicht umfaßt;
(3) Laminieren der Trägers an ein lichtempfindliches Material, und
(4) Belichten des lichtempfindlichen Materials mit actinischer Strahlung durch das gefärbte Bild.

35. Verfahren gemäß Anspruch 34, worin das lichtempfindliche Material ein polymeres Abbildungssystem ist, umfassend eine Schicht eines Materials, daß entweder photohärtbar, photpolymerisierbar, photovernetzbar, photodimerisierbar oder photosolubilisierbar ist, wobei die Schicht an einem Substrat haftet.

## Revendications

1. Un élément pelable pour la formation d'image par voie thermique induite au laser, ledit élément comprenant, dans l'ordre suivant:
(1) un support dimensionnellement stable;
(2) une couche active, ladite couche active étant essentiellement constituée de:
(a) un matériau absorbant dans l'infrarouge, et
(b) un liant polymère;
(3) une couche adhésive;
et
(4) une couche de couverture,
sous réserve que ledit élément ne contienne pas une couche de démoulage interposée entre ladite couche active et ladite couche adhésive,
et dans lequel ledit matériau absorbant dans l'infrarouge est présent en une quantité suffisante pour absorber suffisamment de radiation infrarouge et ainsi permettre de provoquer une modification d'adhérence convenable de la couche active,
et dans lequel la relation adhésive est telle que, lors de l'enlèvement par pelage, les zones de ladite couche active exposées à une radiation infrarouge adhèrent audit support alors que les zones non-exposées de ladite couche active adhérent à ladite couche adhésive et à ladite couche de couverture et sont retirées en même temps que ladite couche adhésive et ladite couche de couverture.

2. L'élément selon la revendication 1 comprenant en outre une couche de revêtement supérieure disposée entre ladite couche active et ladite couche adhésive.

3. L'élément selon la revendication 1 ou la revendication 2, dans lequel ledit élément est choisi dans le groupe constitué de:
polymères de polycarbonates aromatiques, polymères de polysulfones aromatiques; poly(alpha-méthyl styrène); copolymères de N-phénylmaléimide constitués de 3 à 50% de N-phénylmaléimide, 40 à 97% de méthyl méthacrylate, 0 à 35% de styrène et 0 à 35% d'alpha-méthyl styrène; polymères et copolymères acryliques, poly(vinyl pyrrolidone); poly(vinyl pyrrolidone/vinyl acétate); copolymères estérifiés styrène/anhydride maléïque; polyéthylène oxyde; polyesters; et polyamides.

4. L'élément selon la revendication 1 ou la revendication 2, dans lequel ledit support est choisi dans le groupe constitué par le poly(éthylène téréphtalate) et le poly(éthylène naphtalate).

5. Un élément pelable pour la formation d'image par voie thermique induite au laser, ledit élément comprenant, dans l'ordre suivant:
(1) un support dimensionnellement stable;
(2) une couche active, ladite couche active étant essentiellement constituée de :
(a) un matériau absorbant dans l'infrarouge, et
(b) un liant polymère;
(c) un colorant;
(3) une couche adhésive;
et
(4) une couche de couverture,
sous réserve que ledit élément ne contienne pas une couche de démoulage interposée entre ladite couche active et ladite couche adhésive,
et dans lequel ledit matériau absorbant dans l'infrarouge est présent en une quantité suffisante pour absorber suffisamment de radiation infrarouge et ainsi permettre de provoquer une modification d'adhérence convenable de la couche active,
et dans lequel la relation adhésive est telle que, lors de l'enlèvement par pelage, les zones de ladite couche active exposées à une radiation infrarouge adhèrent audit support alors que les zones non-exposées de ladite couche active adhérent à ladite couche adhésive et à ladite couche de couverture et sont retirées en même temps que ladite couche adhésive et ladite couche de couverture.

6. L'élément selon la revendication 5 comprenant en outre une couche de revêtement supérieure entre ladite couche active et ladite couche adhésive.

7. L'élément selon la revendication 5 ou 6 dans lequel ledit liant est choisi dans le groupe constitué de:
polymères de polycarbonates aromatiques, polymères de polysulfones aromatiques; poly(alpha-méthyl styrène); copolymères de N-phénylmaléimide constitués de 3 à 50% de N-phénylmaléimide, 40 à 97% de méthyl méthacrylate, 0 à 35% de styrène et 0 à 35% d'alpha-méthyl styrène; polymères et copolymères acryliques, poly(vinyl pyrrolidone); poly(vinyl pyrrolidone/vinyl acétate); copolymères estérifiés styrène/anhydride maléïque; polyéthylène oxyde; polyesters; et polyamides.

8. L'élément selon la revendication 5 ou la revendication 6, dans lequel ledit support est choisi dans le groupe constitué par le poly(éthylène téréphtalate) et le poly(éthylène naphtalate).

9. Un élément pelable pour la formation d'image par voie thermique induite au laser, ledit élément comprenant, dans l'ordre suivant:
(1) une couche de couverture
(2) une couche adhésive
(3) une couche active, ladite couche active comprenant
(a) un premier liant polymère
(4) une couche absorbante, ladite couche absorbante comprenant:
(a) un matériau absorbant dans l'infrarouge, et
(b) un second liant polymère; et
(5) un support dimensionnellement stable
sous reserve que ledit élément ne contienne pas une couche de démoulage interposée entre ladite couche active et ladite couche adhésive et
dans lequel ledit matériau absorbant dans l'infrarouge est présent en une quantité suffisante pour absorber suffisamment de radiation infrarouge et ainsi provoquer une modification d'adhérence convenable de la couche active et
dans lequel la relation adhésive est telle que, lors de la séparation par pelage, les régions de ladite couche active qui correspondent à des régions dudit élément exposées à une radiation infrarouge adhérent audit support alors que les régions de ladite couche active qui correspondent à des régions non exposées de la dite couche de l'élément adhèrent à ladite couche adhésive et à ladite couche de couverture et sont retirées en même temps que ladite couche adhésive et ladite couche de couverture.

10. L'élément selon la revendication 9, comprenant en outre une couche de revêtement supérieure entre ladite couche active et ladite couche adhésive.

11. L'élément selon la revendication 9 ou la revendication 10, dans laquelle ledit élément est choisi dans le groupe constitué de:
polymères de polycarbonates aromatiques, polymères de polysulfones aromatiques; poly(alpha-méthyl styrène); copolymères de N-phénylmaléimide constitués de 3 à 50% de N-phénylmaléimide, 40 à 97% de méthyl méthacrylate, 0 à 35% de styrène et 0 à 35% d'alpha-méthyl styrène; polymères et copolymères acryliques, poly(vinyl pyrrolidone); poly(vinyl pyrrolidone/vinyl acétate); copolymères estérifiés styrène/anhydride maléïque; polyéthylène oxyde; polyesters; et polyamides.

12. L'élément selon la revendication 9, comprenant en outre une couche collante entre ladite couche active et ladite couche absorbante, ladite couche collante comprenant un troisième liant.

13. L'élément selon la revendication 12, dans lequel ledit troisième liant est un polymère dont la température de transition vitreuse est supérieure à la température ambiante, mais inférieure à 100°C.

14. L'élément selon la revendication 9, dans lequel ledit support est choisi dans le groupe constitué par le poly(éthylène téréphtalate) et le poly(éthylène naphtalate).

15. L'élément selon les revendications 9, 10, 11, 12, 13 ou 14, dans lequel ladite couche active comprend en outre un colorant, ledit colorant étant présent en une quantité suffisante pour conférer à l'image finale la densité optique convenable.

16. L'élément selon l'une quelconque des revendications 9 à 15, dans lequel ledit second liant est un polymère dont la température de transition vitreuse est supérieure à la température ambiante, mais inférieure à 100°C.

17. Un procédé de formation d'une image colorée, ledit procédé comprenant, dans l'ordre indiqué, les étapes suivantes:
(A) exposition pour former une image au travers du support à une radiation infrarouge d'un élément comprenant, dans l'ordre:
(1) ledit support dimensionnellement stable, ledit support étant transparent à une radiation infrarouge;
(2) une couche active ladite couche active comprenant
(a) un premier liant polymère, et
(b) un colorant;
(3) une couche adhésive; et
(4) une couche de couverture;
sous réserve que ledit élément ne contienne pas une couche de démoulage interposée entre ladite couche active et ladite couche adhésive, et
sous la réserve supplémentaire que ledit élément comprenne dans la couche adjacente audit support un matériau absorbant dans l'infrarouge,
dans lequel ledit matériau absorbant dans l'infrarouge est présent en une quantité suffisante pour absorber suffisamment de radiation infrarouge et ainsi provoquer une modification d'adhérence convenable de la couche active, et ledit colorant est présent en une quantité suffisante pour obtenir une image finale présentant la densité optique souhaitée;
(B) séparation par pelage dudit élément en retirant ledit support;
dans lequel dans lequel la relation adhésive est telle que, lors de la séparation par pelage, les régions de ladite couche active qui correspondent à des régions dudit élément exposées à une radiation infrarouge adhérent audit support et sont enlevées en même temps que ledit support alors que les régions de ladite couche active qui correspondent aux régions non exposées dudit élément adhérent à ladite couche adhésive et audit récepteur pour former une image monocolore.

18. Un procédé de formation d'une image colorée, ledit procédé comprenant, dans l'ordre indiqué, les étapes suivantes:
(A) exposition pour former une image au travers du support à une radiation infrarouge d'un élément comprenant, dans l'ordre:
(1) ledit support dimensionnellement stable, ledit support étant transparent à une radiation infrarouge;
(2) une couche active, ladite couche active comprenant
(a) un premier liant polymère, et
(b) un colorant;
(3) une couche adhésive; et
(4) un récepteur
sous réserve que ledit premier élément comprenne dans la couche adjacente au dit support un matériau absorbant dans l'infrarouge,
dans lequel ledit matériau absorbant dans l'infrarouge est présent en une quantité suffisante pour absorber suffisamment de radiation infrarouge et provoquer une modification d'adhérence convenable de la couche active, et ledit colorant est présent en une quantité suffisante pour conférer à l'image finale la densité optique convenable; et
(B) séparation par pelage dudit élément en retirant ledit support;
dans lequel dans lequel la relation adhésive est telle que, lors de la séparation par pelage, les régions de ladite couche active qui correspondent à des régions dudit élément exposées à une radiation infrarouge adhérent audit support et sont enlevées en même temps que ledit support alors que les régions de ladite couche active qui correspondent aux régions non exposées dudit élément adhérent à ladite couche adhésive et audit récepteur pour former une image monocolore.

19. Un procédé de formation d'une image multicolore, ledit procédé comprenant, dans l'ordre indiqué, les étapes suivantes:
(A) exposition pour former une image à une radiation infrarouge d'un premier élément comprenant, dans l'ordre:
(1) un support dimensionnellement stable, ledit support étant transparent à une radiation infrarouge;
(2) une couche active, ladite couche active comprenant
(a) un premier liant polymère, et
(b) un colorant;
(3) une couche adhésive; et
(4) un récepteur
sous réserve que ledit premier élément comprenne dans la couche adjacente au dit support un matériau absorbant dans l'infrarouge,
dans lequel ledit matériau absorbant dans l'infrarouge est présent en une quantité suffisante pour absorber suffisamment de radiation infrarouge et ainsi provoquer une modification d'adhérence convenable de la couche active, et ledit colorant est présent en une quantité suffisante pour conférer à l'image finale la densité optique convenable; et
(B) séparation par pelage dudit premier élément en retirant ledit support; dans lequel la relation adhésive est telle que, lors de la séparation par pelage, les régions de ladite couche active qui correspondent à des régions dudit élément exposées à une radiation infrarouge adhérent audit support alors que les régions de ladite couche active qui correspondent à des régions non exposées de la dite couche du premier élément adhèrent à ladite couche adhésive et audit récepteur pour former une image monocolore;
(C) stratification d'un second élément sur l'image formée dans l'étape précédente pour obtenir un élément intermédiaire, ledit second élément contenant, dans l'ordre indiqué:
(1) ledit support dimensionnellement stable, ledit support étant transparent à une radiation infrarouge;
(2) une couche active, ladite couche active comprenant
(a) un premier liant polymère, et
(b) un colorant;
(3) une couche adhésive;
ladite couche adhésive étant stratifiée sur la couche active exposée de ladite image formée dans l'étape précédente;
sous réserve que ledit second élément comprenne dans la couche adjacente au dit support un matériau absorbant dans l'infrarouge,
dans lequel ledit matériau absorbant dans l'infrarouge est présent en une quantité suffisante pour absorber suffisamment de radiation infrarouge et ainsi provoquer une modification d'adhérence convenable de la couche active, et ledit colorant est présent en une quantité suffisante pour conférer à l'image finale la densité optique convenable;
(D) exposition dudit élément intermédiaire pour former une image à une radiation infrarouge au travers dudit support dudit élément intermédiaire; ladite exposition étant mise en oeuvre en respectant les repères de l'image déjà formée au préalable.
(E) séparation par pelage dudit premier élément en retirant ledit support; dans lequel la relation adhésive est telle que, lors de la séparation par pelage, les régions de ladite couche active qui correspondent à des régions dudit élément exposés à une radiation infrarouge adhérent audit support alors que les régions de ladite couche active qui correspondent à des régions non exposées de la dite couche de l'élément intermédiaire adhèrent à ladite couche adhésive pour former une image multicolore.

20. Le procédé selon la revendication 19, dans lequel le premier et le second liants sont choisis dans le groupe constitué de:
polymères de polycarbonates aromatiques, polymères de polysulfones aromatiques; poly(alpha-méthyl styrène); copolymères de N-phénylmaléimide constitués de 3 à 50% de N-phénylmaléimide, 40 à 97% de méthyl méthacrylate, 0 à 35% de styrène et 0 à 35% d'alpha-méthyl styrène; polymères et copolymères acryliques, poly(vinyl pyrrolidone); poly(vinyl pyrrolidone/vinyl acétate); copolymères estérifiés styrène/anhydride maléïque; polyéthylène oxyde; polyesters; et polyamides.

21. Le procédé selon la revendication 19, dans lequel ledit premier élément contient en outre une couche absorbante disposée entre ledit support et ladite couche adhésive, ledit matériau infrarouge étant présent dans ladite couche absorbante laquelle couche absorbante comprend un troisième liant.

22. Le procédé selon la revendication 21, dans lequel ledit troisième liant est un polymère dont la température de transition vitreuse est supérieure à la température ambiante, mais inférieure à 100°C.

23. Le procédé selon la revendication 21, dans lequel ledit premier élément comprend en outre une couche collante disposée entre ladite couche active et ladite couche absorbante, ladite couche collante comprenant un quatrième liant.

24. Le procédé selon la revendication 23, dans lequel ledit quatrième liant est un polymère dont la température de transition vitreuse est supérieure à la température ambiante, mais inférieure à 100°C.

25. Le procédé selon la revendication 19, 21 ou 23, dans lequel les étapes (C) à (E) sont mises en oeuvre à trois reprises pour former une image multicolore constituée d'images en jaune, cyan, magenta et noir.

26. Un procédé de formation d'une image en couleurs, ledit procédé comprenant, dans l'ordre indiqué, les étapes suivantes:
(A) exposition, au travers du support pour former une image, à une radiation infrarouge, d'un élément comprenant dans l'ordre :
(1) un support dimensionnellement stable, ledit support étant transparent à une radiation infrarouge;
(2) une couche active, ladite couche active comprenant
(a) un premier liant polymère, et
(b) un colorant;
(3) une couche adhésive; et
(4) un récepteur
sous réserve que ledit premier élément comprenne dans la couche adjacente au dit support un matériau absorbant dans l'infrarouge,
dans lequel ledit matériau absorbant dans l'infrarouge est présent en une quantité suffisante pour absorber suffisamment de radiation infrarouge et ainsi provoquer une modification d'adhérence convenable de la couche active;
(B) séparation par pelage dudit élément en retirant ledit support;
dans lequel la relation adhésive est telle que, lors de la séparation par pelage, les régions de ladite couche active qui correspondent à des régions dudit élément exposées à une radiation infrarouge adhérent audit support et sont retirées en même temps que ledit support exposant ladite couche adhésive, alors que les régions de ladite couche active qui correspondent à des régions non exposées dudit élément adhèrent à ladite couche adhésive et audit récepteur; et
(C) application de toner sur les régions exposées de ladite couche adhésive pour former une image monocolore.

27. Un procédé de formation d'une image multicolore, ledit procédé comprenant, dans l'ordre indiqué, les étapes suivantes:
(A) exposition pour former une image d'un premier élément à une radiation infrarouge comprenant, dans l'ordre:
(1) un support dimensionnellement stable, ledit support étant transparent à une radiation infrarouge;
(2) une couche active, ladite couche active comprenant un premier liant polymère,
(3) une couche adhésive; et
(4) un récepteur
sous réserve que ledit premier élément comprenne un matériau absorbant dans l'infrarouge dans la couche adjacente au dit support,
dans lequel ledit matériau absorbant dans l'infrarouge est présent en une quantité suffisante pour absorber suffisamment de radiation infrarouge et ainsi provoquer une modification d'adhérence convenable de la couche active;
(B) la séparation par pelage dudit premier élément en retirant ledit support; dans lequel la relation adhésive est telle que, lors de la séparation par pelage, les régions de ladite couche active qui correspondent à des régions dudit premier élément exposées à une radiation infrarouge adhérent audit support et sont retirées en même temps que ledit support exposant ladite couche adhésive, alors que les régions de ladite couche active qui correspondent à des régions non exposées dudit premier élément adhèrent à ladite couche adhésive et audit récepteur;
(C) application de toner sur les régions exposées de ladite couche adhésive pour former une image monocolore;
(D) stratification d'un second élément sur l'image formée dans l'étape précédente pour former un élément intermédiaire ledit second élément contenant, dans l'ordre indiqué:
(1) un support dimensionnellement stable, ledit support étant transparent à une radiation infrarouge;
(2) une couche active, ladite couche active comprenant un second liant, et
(3) une couche adhésive, ladite couche adhésive dudit second élément étant stratifiée sur ladite couche active chargée de toner de ladite image formée dans l'étape précédente;
sous réserve que ledit second élément comprenne un matériau absorbant dans l'infrarouge dans la couche adjacente au dit support,
dans lequel ledit matériau absorbant dans l'infrarouge est présent en une quantité suffisante pour absorber suffisamment de radiation infrarouge et ainsi provoquer une modification d'adhérence convenable de la couche active;
(E) exposition dudit élément intermédiaire pour former une image à une radiation infrarouge au travers dudit support dudit élément intermédiaire, ladite exposition étant mise en oeuvre en respectant les repères de l'image formée au préalable;
(F) séparation par pelage dudit élément intermédiaire en enlevant ledit support dans lequel la relation adhésive est telle que, lors du pelage, les régions de ladite couche active qui correspondent à des régions dudit élément intermédiaire exposées à une radiation infrarouge adhérent audit support et sont enlevées en même temps que ledit support en exposant ladite couche adhésive, alors que des régions de ladite couche adhésive qui correspondent à des régions non exposées de ladite couche dudit élément intermédiaire adhérent à ladite couche adhésive;
(G) application de toner sur les régions exposées de ladite couche adhésive dudit élément intermédiaire pour former une image multicolore.

28. L'élément selon la revendication 27 dans laquelle ledit élément est choisi dans le groupe constitué de:
polymères de polycarbonates aromatiques, polymères de polysulfones aromatiques; poly(alpha-méthyl styrène); copolymères de N-phénylmaléimide constitués de 3 à 50% de N-phénylmaléimide, 40 à 97% de méthyl méthacrylate, 0 à 35% de styrène et 0 à 35% d'alpha-méthyl styrène; polymères et copolymères acryliques, poly(vinyl pyrrolidone); poly(vinyl pyrrolidone/vinyl acétate); copolymères estérifiés styrène/anhydride maléïque; polyéthylène oxyde; polyesters; et polyamides.

29. Le procédé selon la revendication 28 dans lequel ledit premier élément contient en outre une couche absorbante disposée entre ledit support et ladite couche adhésive, ledit matériau infrarouge étant présent dans ladite couche absorbante laquelle couche absorbante comprend un troisième liant.

30. Le procédé selon la revendication 29 dans lequel ledit troisième liant est un polymère dont la température de transition vitreuse est supérieure à la température ambiante mais inférieure à 100°C.

31. Le procédé selon la revendication 29, dans lequel ledit premier élément comprend en outre une couche collante disposée entre ladite couche active et ladite couche absorbante, ladite couche collante comprenant un quatrième liant

32. Le procédé selon la revendication 31, dans lequel ledit troisième liant est un polymère dont la température de transition vitreuse est supérieure à la température ambiante, mais inférieure à 100°C

33. Le procédé selon la revendication 29 ou 31 dans lequel les étapes (D) à (G) sont mises en oeuvre 0 trois reprises pour former une image multicolore constituée d'images en jaune, cyan, magenta et noir.

34. Un procédé de formation d'une image, ledit procédé comprenant lesdites étapes mises en oeuvre dans l'ordre indiqué sauf que l'étape (3) est mise en oeuvre soit avant soit après l'étape (2):
(1) exposition pour former une image à une radiation infrarouge d'un élément pelable pour la formation d'une image par voie thermique induite au laser, ledit élément comprenant, dans l'ordre:
(a) un support dimensionnellement stable;
(b) une couche active, ladite couche active étant essentiellement constituée: d'un matériau absorbant dans l'infrarouge, d'un premier liant polymère et d'un colorant;
(c) une couche adhésive;
(d) une couche de couverture;
dans lequel ledit matériau absorbant dans l'infrarouge est présent en une quantité suffisante pour absorber suffisamment de radiation infrarouge et ainsi provoquer une modification d'adhérence convenable de la couche active;
dans lequel la relation adhésive est telle que, lors du pelage, les régions de ladite couche active exposées à une radiation infrarouge adhérent audit support, alors que des régions non-exposées de ladite couche active adhérent à ladite couche adhésive et à ladite couche de couverture et sont retirées en même temps que ladite couche adhésive et ladite couche de couverture,
(2) séparation par pelage dudit élément pour former une image colorée, ladite image colorée, ladite image colorée comprenant ledit support et les portions exposées de ladite couche active;
(3) stratification dudit support sur un matériau photosensible; et
(4) exposition dudit matériau photosensible à une radiation actinique au travers de ladite image colorée.

35. Le procédé selon la revendication 34, dans lequel ledit matériau photosensible est un système de formation d'images à base de polymères comprenant une couche d'un matériau qui est photodurcissable, photopolymérisable, photoréticulable, photodimérisable, ou photosolubilisable, ladite couche adhérant à un substrat.
